# EUROPEAN PATENT APPLICATION

(11) **EP 4 773 771 A1**
(43) Date of publication of application: **08.07.2026**
(21) Application number: 24909738.7
(22) Date of filing: 31.07.2024
(51) Int. Cl.: H10K 59/122, H01L 23/00

(54) **DISPLAY SUBSTRATE, DISPLAY PANEL, AND DISPLAY DEVICE**

(30) Priority: 29.12.2023 WO PCT/CN2023/143095
(71) Applicant: BOE Technology Group Co., Ltd., Beijing 100015 (CN); Chengdu BOE Optoelectronics Technology Co., Ltd., Chengdu, Sichuan 611731 (CN); Beijing BOE Technology Development Co., Ltd., Daxing District Beijing 100176 (CN)
(72) Inventor: ZHAO, Erjin, Beijing 100176 (CN); ZHANG, Tiaomei, Beijing 100176 (CN); WANG, Hongli, Beijing 100176 (CN); FAN, Cong, Beijing 100176 (CN); SHI, Bo, Beijing 100176 (CN); ZHANG, Bo, Beijing 100176 (CN); YU, Ziyang, Beijing 100176 (CN); SONG, Gukhwan, Beijing 100176 (CN); JIANG, Zhiliang, Beijing 100176 (CN); DONG, Xiangdan, Beijing 100176 (CN); HU, Ming, Beijing 100176 (CN)
(74) Representative: Brötz, Helmut
(86) International application number: PCT/CN2024/108812
(87) International publication number: WO 2025/138784

(57) **Abstract**

A display substrate, a display panel, and a display device. The display substrate comprises sub-pixels, a pixel defining layer, a first defining structure, and a support structure; the pixel defining layer comprises a plurality of openings and a pixel defining portion; the plurality of openings comprise a plurality of first openings and a plurality of second openings; the first defining structure comprises a first portion overlapping with the pixel defining portion and a second portion exposed out of the second openings; the second portion of the first defining structure is configured to isolate at least one layer in a light-emitting function layer; the minimum distance between the orthographic projection of the support structure on a base substrate and the orthographic projection of the first defining structure on the base substrate is a first distance; the minimum distance to the orthographic projection of the second openings on the base substrate is a second distance; and the first distance and the second distance are both greater than 0 micrometer and less than 10 micrometers. Therefore, the support structure has a good shape and provides reliable support force while the light-emitting function layer is isolated to reduce crosstalk.

## Description

The present application claims priority to the patent application No. PCT/CN2023/143095 filed on December 29, 2023, the content of which is hereby incorporated in its entirety by reference as a part of the present application for all purposes.

### TECHNICAL FIELD

The present disclosure relates to a display substrate, a display panel and a display device.

### BACKGROUND

The organic light-emitting diode (OLED) display device is deeply favored by users because of its advantages such as rich colors, short response time and capability of being folded. An organic light-emitting display device with a tandem structure improves the life and brightness of a light-emitting device by adding at least one light-emitting layer and a charge-generating layer in the organic light-emitting device, and reduces the power consumption, so as to satisfy the demand of users for the power consumption and service life of the display device.

### SUMMARY

The embodiments of the present disclosure provide a display substrate, a display panel and a display device.

At least one embodiment of the present disclosure provides a display substrate, which includes: a base substrate, a plurality of sub-pixels, a pixel defining layer and at least one first defining structure, the plurality of sub-pixels are located on the base substrate, each of the plurality of sub-pixels include a light-emitting functional layer, the light-emitting functional layer includes a plurality of film layers; the pixel defining layer includes a plurality of openings and a pixel defining portion surrounding the plurality of openings, the plurality of openings includes a plurality of first openings and a plurality of second openings, each of the plurality of first openings is configured to define a light-emitting region of the sub-pixel, at least a portion of at least one layer of the light-emitting functional layer located in the first opening is a continuous portion, and at least a portion of the at least one layer of the light-emitting functional layer located in each of the plurality of second openings is isolated; each of the at least one first defining structure includes a first portion overlapping with the pixel defining portion and a second portion exposed by the second opening, the second portion of the first defining structure is configured to isolate the at least one layer of the light-emitting functional layer, the display substrate further includes at least one support structure, a minimum distance between an orthogonal projection of each of the at least one support structure on the base substrate and an orthogonal projection of the first defining structure on the base substrate is a first distance, a minimum distance between the orthogonal projection of the support structure on the base substrate and an orthogonal projection of the second opening on the base substrate is a second distance, and both the first distance and the second distance are greater than 0 micron and less than 10 microns.

For example, according to at least one embodiment of the present disclosure, both the first distance and the second distance are not less than 2 microns.

For example, according to at least one embodiment of the present disclosure, a straight-line distance between any two points on an edge of a cross section of the support structure taken by a plane parallel to the base substrate is not greater than 20 microns.

For example, according to at least one embodiment of the present disclosure, at least a portion of a surface of the support structure away from the base substrate is farther away from the base substrate than the pixel defining portion, and a cross section of the support structure taken by a plane parallel to the base substrate is circular, elliptical or polygonal.

For example, according to at least one embodiment of the present disclosure, in a direction perpendicular to the base substrate, a size of the support structure is not greater than 10 microns.

For example, according to at least one embodiment of the present disclosure, the first portion of the first defining structure covers the pixel defining portion, and a slope angle is formed between at least a portion of a side surface of the first portion of the first defining structure away from the second portion of the first defining structure and a first surface of the first portion close to the base substrate, and an angle between the at least a portion of the side surface and a portion of the first surface close to the second portion is less than 90 degrees.

For example, according to at least one embodiment of the present disclosure, in an arrangement direction of adjacent sub-pixels, a maximum size of a cross section of the first defining structure between the adjacent sub-pixels that is taken by a plane is a first size, and a maximum size of a cross section of the first portion of the first defining structure that is taken by the plane is a second size, the second size is not less than 1/2 of the first size and not greater than 10 microns, the plane is parallel to the arrangement direction of the adjacent sub-pixels and perpendicular to the base substrate.

For example, according to at least one embodiment of the present disclosure, the plurality of sub-pixels include a plurality of first sub-pixels, a plurality of second sub-pixels and a plurality of third sub-pixels, and a repeating unit is constituted by one of the plurality of sub-pixels, one of the plurality of second sub-pixels and one of the plurality of third sub-pixels, and in the repeating unit, the first sub-pixel and the second sub-pixel are arranged sequentially in a first arrangement direction and located at one side of the third sub-pixel in a second arrangement direction, the first arrangement direction intersects with the second arrangement direction.

For example, according to at least one embodiment of the present disclosure, any two adjacent sub-pixels among the first sub-pixel, the second sub-pixel and the third sub-pixel have one first defining structure and one second opening disposed therebetween, and light-emitting regions of the adjacent sub-pixels are at unequal distances from the second opening between the adjacent sub-pixels, and the second portion of the first defining structure is located between the first portion of the first defining structure and the light-emitting region of one of the adjacent sub-pixels that is closer to the second opening.

For example, according to at least one embodiment of the present disclosure, a length of an edge of the first defining structure close to the first opening of the sub-pixel is smaller than a length of an edge of the second opening close to the first opening of the sub-pixel, and two ends of the second opening in its extending direction are located at two sides of the first defining structure overlapping with the second opening.

For example, according to at least one embodiment of the present disclosure, the plurality of sub-pixels include a plurality of first sub-pixels, a plurality of second sub-pixels and a plurality of third sub-pixels, the plurality of sub-pixels are arranged in a plurality of first sub-pixel sets and a plurality of second sub-pixel sets disposed alternately in a first arrangement direction, each of the plurality of first sub-pixel sets includes one of the plurality of first sub-pixels and one of the plurality of second sub-pixels disposed alternately in a second arrangement direction, and each of the second sub-pixel sets includes multiple third sub-pixels of the plurality of third sub-pixels arranged in the second arrangement direction, the first arrangement direction intersects with the second arrangement direction; and each of the plurality of first sub-pixel sets and each of the plurality of second sub-pixel sets are distributed in a staggered manner in the second arrangement direction, each of at least some of the plurality of first sub-pixels is surrounded by eight sub-pixels, and the eight sub-pixels include second sub-pixels and third sub-pixels disposed alternately.

For example, according to at least one embodiment of the present disclosure, the display substrate includes: a first region, a second region and a third region, the first region is configured for display, at least some of the plurality of sub-pixels are located in the first region; the first region is located at at least one side of the second region; the third region is located between the first region and the second region, the display substrate includes at least one second defining structure located in the third region, an orthogonal projection of each of the least one second defining structure on the base substrate has an annular shape and surrounds the second region, a material of the second defining structure is the same as that of the first defining structure, and at least one layer of the light-emitting functional layer is isolated by an edge portion of the second defining structure not overlapping with the pixel defining portion.

For example, according to at least one embodiment of the present disclosure, the plurality of openings of the pixel defining layer include a third opening, the third opening is located in the third region and configured to expose at least a portion of the second defining structure, the at least one second defining structure includes at least one of a first sub-defining structure and a second sub-defining structure, the first sub-defining structure is completely exposed by the third opening, and the second sub-defining structure includes a third portion overlapping with the pixel defining portion and a fourth portion exposed by the third opening, and the fourth portion of the second sub-defining structure is configured to isolate the at least one layer of the light-emitting functional layer.

For example, according to at least one embodiment of the present disclosure, the display substrate further includes a third defining structure, the third defining structure is located in the third region and between the second defining structure and the second region, the pixel defining portion is located at a side of the third defining structure away from the second region, and the third defining structure is configured to isolate at least one film layer of the light-emitting functional layer.

For example, according to at least one embodiment of the present disclosure, an edge of a surface of each of at least one of the first defining structure, the second defining structure and the third defining structure away from the base substrate protrudes relative to an edge of a surface of the each of at least one of the first defining structure, the second defining structure and the third defining structure close to the base substrate.

For example, according to at least one embodiment of the present disclosure, the first portion of the first defining structure is covered by the pixel defining portion, and an area of the light-emitting region of each of the plurality of third sub-pixels is smaller than that of the light-emitting region of each of the plurality of second sub-pixels, and a distance between the second opening located between the second sub-pixel and the third sub-pixel and the light-emitting region of the third sub-pixel is not smaller than, a distance between the second opening located between the second sub-pixel and the third sub-pixel and the light-emitting region of the second sub-pixel.

For example, according to at least one embodiment of the present disclosure, in an arrangement direction of adjacent sub-pixels, a maximum size of a cross section of the first defining structure between the adjacent sub-pixels that is taken by a plane is a first size, and a maximum size of a cross section of the first portion of the first defining structure that is taken by the plane is a second size, the second size is not less than 1/2 of the first size, the plane is parallel to the arrangement direction of the adjacent sub-pixels and perpendicular to the base substrate.

For example, according to at least one embodiment of the present disclosure, a length of the second opening in its extending direction is not equal to a length of the first defining structure in its extending direction.

For example, according to at least one embodiment of the present disclosure, a length of the second opening in its extending direction is equal to a length of the first defining structure in its extending direction, and the first distance is not equal to the second distance.

For example, according to at least one embodiment of the present disclosure, a maximum size, in the arrangement direction of adjacent sub-pixels, of a cross section of the second opening taken by the plane is not greater than 10 microns.

For example, according to at least one embodiment of the present disclosure, a length of the second opening in its extending direction is not greater than 50 microns.

For example, according to at least one embodiment of the present disclosure, a distance between the first defining structure and a first electrode of the sub-pixel is not greater than 15 microns.

For example, according to at least one embodiment of the present disclosure, a length of an edge of the first defining structure close to the light-emitting region of the sub-pixel is not greater than 50 microns.

For example, according to at least one embodiment of the present disclosure, the plurality of sub-pixels are arranged in a plurality of sub-pixel rows and a plurality of sub-pixel columns, and in a direction parallel to the base substrate, a distance between adjacent first defining structures located between two adjacent sub-pixel rows is not greater than 40 microns, and a distance between adjacent first defining structures located between two adjacent sub-pixel columns is not greater than 40 microns.

Another embodiment of the present disclosure provides a display panel, which includes the display substrate according to any display substrate as mentioned above.

Another embodiment of the present disclosure provides a display device, which includes the display substrate according to any display substrate as mentioned above.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1 is a schematic diagram of a partial planar structure of a display substrate provided by at least one embodiment the present disclosure.
Fig. 2 is a schematic diagram of a partial cross-sectional structure taken along the line AA' shown in Fig. 1.
Fig. 3 is a schematic diagram of a partial cross-sectional structure taken along the line BB' shown in Fig. 1.
Fig. 4A is a schematic diagram of a plurality of first electrodes and a plurality of first defining structures in the display substrate shown in Fig. 1.
Fig. 4B is a schematic diagram of another first defining structure and a support structure provided by at least one embodiment of the present disclosure.
Fig. 5 is a schematic diagram of a partial planar structure of another display substrate provided by at least one embodiment the present disclosure.
Fig. 6 is a schematic diagram of a partial cross-sectional structure taken along the line CC' shown in Fig. 5.
Fig. 7 is a schematic diagram of a partial cross-sectional structure of another display substrate provided by at least one embodiment of the present disclosure.
Fig. 8 is a planar diagram of yet another display substrate provided by at least one embodiment of the present disclosure.
Fig. 9 is a schematic diagram of a partial cross-sectional taken along the line W1-W1' shown in Fig. 8.
Fig. 10 is a schematic diagram of a partial cross-sectional of yet another display substrate provided by at least one embodiment of the present disclosure.
Fig. 11 is schematic diagram of a partial cross-sectional of yet another display substrate provided by at least one embodiment of the present disclosure.
Fig. 12 is a schematic diagram of a partial planar structure provided according to an example of an embodiment of the present disclosure.
Fig. 13 is a schematic diagram of a partial cross-sectional structure taken along the AA' line shown in Fig. 12.
Fig. 14 is a partial enlarged view of the display substrate shown in Fig. 12.
Fig. 15 is a schematic diagram of a partial planar structure of a display substrate provided according to another example of an embodiment of the present disclosure.
Fig. 16 is a schematic diagram of a partial cross-sectional structure of a display substrate provided according to another example of an embodiment of the present disclosure.
Fig. 17 and Fig. 18 are schematic diagrams of partial cross-sectional structures of a display substrate provided according to different examples of an embodiment of the present disclosure.
Fig. 19 is a schematic diagram of a partial planar structure of a display substrate provided according to another example of an embodiment of the present disclosure.
Fig. 20 is a schematic diagram of a partial cross-sectional structure taken along the CC' line shown in Fig. 19.
Fig. 21 is a schematic diagram of a partial cross-sectional structure of a display substrate provided according to another example of an embodiment of the present disclosure.
Fig. 22 is a schematic diagram of a partial planar structure of a display substrate provided according to another example of an embodiment of the present disclosure.
Fig. 23 is a schematic diagram of a partial cross-sectional structure taken along the DD' line shown in Fig. 22.
Fig. 24 and Fig. 25 are schematic diagrams of partial planar structures of a display substrate provided according to different examples of an embodiment of the present disclosure.
Fig. 26 is a schematic diagram of a partial cross-sectional structure taken along the EE' line shown in Fig. 24.
Fig. 27 is a schematic diagram of a partial cross-sectional structure taken along the FF' line shown in Fig. 25.
Fig. 28 is a schematic diagram of a partial planar structure of the display substrate provided according to another example of an embodiment of the present disclosure.
Fig. 29 is a partial enlarged view of the display substrate shown in Fig. 28.
Fig. 30 is a schematic diagram of a partial cross-sectional structure of a display substrate provided according to another embodiment of the present disclosure.
Fig. 31 is a schematic block diagram of a display device provided according to another embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "approximately the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two.

The Tandem technology is to stack and connect in series the sub-pixel light-emitting layers, and provide a whole charge-generating layer between the stacked light-emitting layers, such as a P-type doped charge-generating layer P-CGL and an N-type doped charge-generating layer N-CGL. Compared to a display substrate without a Tandem device, the Tandem device has two light-emitting layers connected in series, so that series connection of two light-emitting devices may be enabled, and under the same luminous intensity, the luminous current of light-emitting device is greatly reduced, the life of organic light-emitting device is improved, and power consumption is reduced.

During the research, the inventor of the present application has found that: because of the series connection of the two light-emitting layers in the Tandem device, higher requirements are imposed on materials, the evaporation process and the like; furthermore, the charge-generating layer in the Tandem device has a high conductivity, and the charge-generating layer of adjacent two sub-pixels is a continuous film and may have a phenomenon of charge transverse migration, which may lead to crosstalk between adjacent sub-pixels, resulting in the color shift of the display substrate. Moreover, in response to that a support structure (usually located between adjacent sub-pixels), which is used to support a mask, is disposed in a display substrate, the support structure may be significantly influenced by the morphology of the pixel defining portion. For example, the pixel defining portion may include a pixel opening, and a defining opening used to form an isolation structure, and slope angles formed by and the thicknesses of the pixel defining portion at the individual openings may influence the morphology of the support structure. For example, the support structure may be caused to be tilted or have thickness non-uniformity, which may damage supporting effect.

At least one embodiment of the present disclosure provides a display substrate, the display substrate includes: a base substrate, a plurality of sub-pixels, a pixel defining layer, at least one first defining structure and at least one support structure, the plurality of sub-pixels are located on the base substrate, each of the plurality of sub-pixels include a light-emitting functional layer, the light-emitting functional layer includes a plurality of film layers; the a pixel defining layer includes a plurality of openings and a pixel defining portion surrounding the plurality of openings, the plurality of openings includes a plurality of first openings and a plurality of second openings, each of the plurality of first openings is configured to define a light-emitting region of the sub-pixel, at least a portion of at least one layer of the light-emitting functional layer located in the first opening is a continuous portion, and at least a portion of the at least one layer of the light-emitting functional layer located in each of the plurality of second openings is isolated; each of the at least one first defining structure includes a first portion overlapping with the pixel defining portion and a second portion exposed by the second opening, the second portion of the first defining structure is configured to isolate the at least one layer of the light-emitting functional layer, a minimum distance between an orthogonal projection of each of the at least one support structure on the base substrate and an orthogonal projection of the first defining structure on the base substrate is a first distance, a minimum distance between the orthogonal projection of the support structure on the base substrate and an orthogonal projection of the second opening on the base substrate is a second distance, and both the first distance and the second distance are greater than 0 micron and less than 10 microns.

In the display substrate in the present disclosure, on one hand, the first portion of the first defining structure overlaps with the pixel defining portion, and the second portion of the first defining structure may isolate at least one film layer of the light-emitting functional layer, so that sub-pixels may be ensured to have electrodes of good flatness and emit light with good effects, and at the same time, the risk of crosstalk between adjacent sub-pixels may be reduced; on the other hand, with the first distance between the support structure and the first defining structure and the second distance between the support structure and the second opening kept within the above-mentioned range, both the pixel defining portion and the support structure may be enabled to have good morphology, which facilitates good effect of mask supporting by the support structure and a minor impact on process and productivity.

The display substrate, the display panel and the display device in the embodiments of the present disclosure will be described in the following with reference to the accompanying drawings.

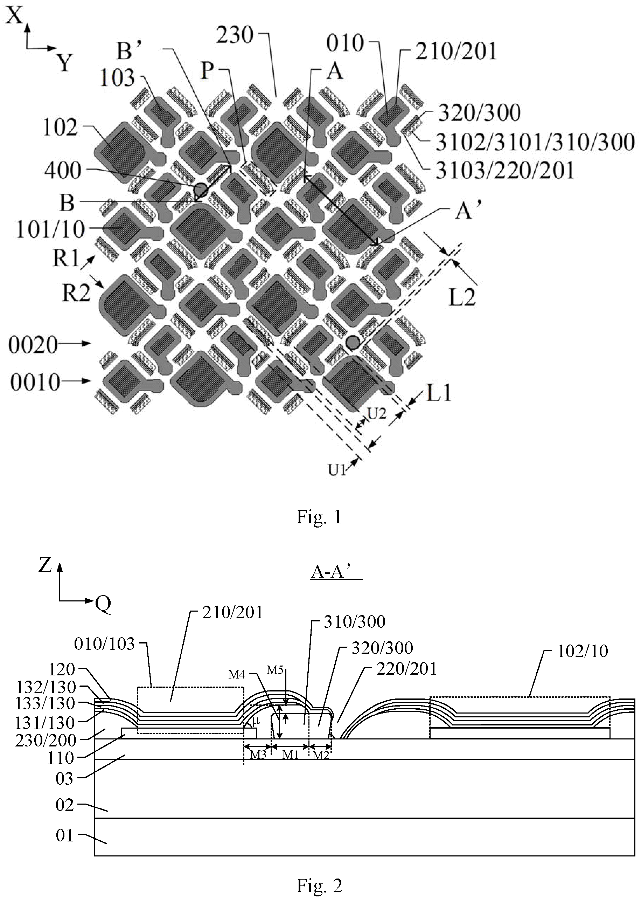

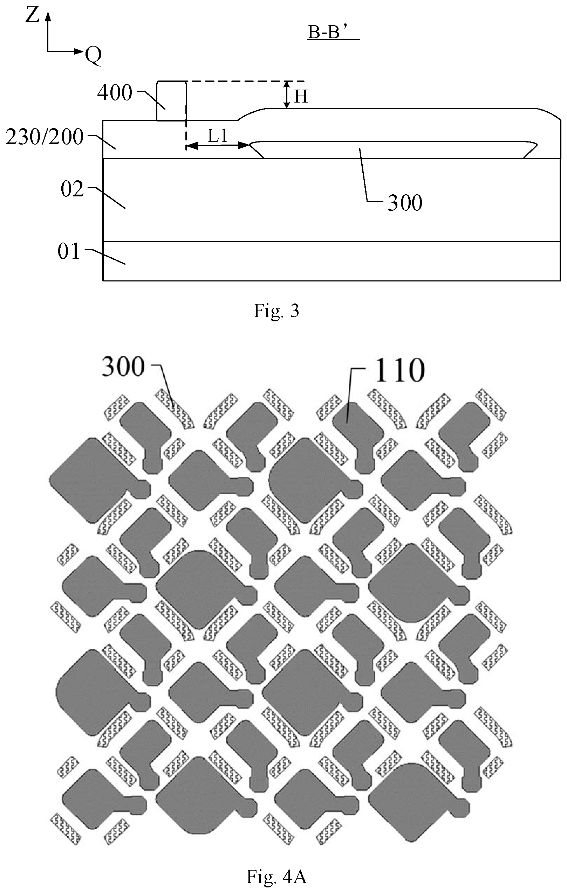

Fig. 1 is a schematic diagram of a partial planar structure of a display substrate provided by at least one embodiment the present disclosure. Fig. 2 is a schematic diagram of a partial cross-sectional structure taken along the line AA' shown in Fig. 1. Fig. 3 is a schematic diagram of a partial cross-sectional structure taken along the line BB' shown in Fig. 1. Fig. 4A is a schematic diagram of a plurality of first electrodes and a plurality of first defining structures in the display substrate shown in Fig. 1.

As shown in Fig. 1, the display substrate includes a base substrate 01, as well as a plurality of sub-pixels 10, a pixel defining layer 200 and at least one first defining structure 300 located on the base substrate 01. At least some of the plurality of sub-pixels 10 include a light-emitting functional layer 130, the light-emitting functional layer 130 includes a plurality of film layers. For example, the at least some of the plurality of sub-pixels 10 mentioned above are located in a region of the display substrate that is used for image display (e.g., the first region in the embodiments below), and the display substrate further includes a peripheral region surrounding the display region.

For example, as shown in Fig. 2, the sub-pixel 10 further includes a first electrode 110 and a second electrode 120 on two sides of the light-emitting functional layer 130 in a direction perpendicular to the base substrate 01 (e.g., the direction Z shown in Fig. 2), and the first electrode 110 is located between the light-emitting functional layer 130 and the base substrate 01. For example, the light-emitting functional layer 130 may include light-emitting layers used to emit light and a charge-generating layer 133. The charge-generating layer 133 has relatively strong conductivity, so that the light-emitting functional layer 130 may have advantages such as a long lifespan, low power consumption and the capability of enabling high luminance. For example, the light-emitting functional layer 130 may be a film layer in an organic light-emitting element. For example, the light-emitting functional layer 130 may include a first light-emitting layer (EML) 131, a charge-generating layer (CGL) 133 and a second light-emitting layer (EML) 132 that are stacked, the charge-generating layer 133 is located between the first light-emitting layer 131 and the second light-emitting layer 132. It is to be noted that, the light-emitting functional layer 130 shown in Fig. 2 may further include other film layers, such as a hole injection layer (HIL), a hole transport layer (HTL), an electron transport layer (ETL) and an electron injection layer (EIL), the embodiments of the present disclosure do not limit this. For example, the hole injection layer, the hole transport layer, the electron transport layer, the electron injection layer, the charge-generating layer 133 and the second electrode 120 are all film layers shared by a plurality of sub-pixels 10 and may be referred to as common layers. Moreover, the thicknesses of the individual film layers shown in Fig. 2 are only for the purpose of illustrating the film layers clearly and does not represent their actual sizes.

For example, as shown in Fig. 2, the sub-pixel 10 may include a tandem light-emitting element, such as a tandem OLED, but the embodiments of the present disclosure are not limited to this.

For example, as shown in Fig. 2, there may be other structures 02 disposed at the side of the first electrode 110 of the sub-pixel 10 that faces the base substrate 01. The other structures 02 include, for example, a pixel circuit electrically connected with the first electrode 110 of the sub-pixel 10, a signal line and various insulating layers. For example, the various insulating layers may include a passivation layer, a buffer layer, a gate insulating layer, an inter-layer insulating layer and the like.

As shown in Fig. 1 and Fig. 2, the pixel defining layer 200 includes a plurality of openings 201 and a pixel defining portion 230 surrounding the plurality of openings 201. The plurality of openings 201 in the pixel defining layer 200 include a plurality of first openings 210 and a plurality of second openings 220. The first opening 210 is configured to define the light-emitting region 010 of the sub-pixel 10. At least a portion of at least one layer of the light-emitting functional layer 130 located in the first opening 210 is continuous, while at least a portion of the at least one layer of the light-emitting functional layer 130 located in the second opening 220 is isolated.

For example, as shown in Fig. 1 and Fig. 2, the first opening 210 may be a pixel opening, which is used to define the light-emitting region 010 of the sub-pixel 10, and the portion of the light-emitting functional layer 130 located in the first opening 210 can be driven to emit light by the first electrode 110 and second electrode 120 on the two sides of the light-emitting functional layer 130. The light-emitting region 010 mentioned above may refer to an active light-emitting region of the sub-pixel 10. The shape of the light-emitting region 010 may refer to a two-dimensional shape. For example, the shape of the light-emitting region 010 may be the same as the shape of the orthogonal projection, on the base substrate 01, of the portion of the first electrode 110 exposed by the first opening 210.

For example, as shown in Fig. 1 and Fig. 2, the second opening 220 of the pixel defining layer 200 is located between adjacent sub-pixels 10. For example, the area of the orthogonal projection of the second opening 220 on the base substrate 01 is smaller than the area of the orthogonal projection of the first opening 210 on the base substrate 01.

As shown in Fig. 1 and Fig. 2, the first defining structure 300 is located between adjacent sub-pixels 10, the first defining structure 300 includes a first portion 310 overlapping with the pixel defining portion 230, and a second portion 320 exposed by a second opening 220, and the second portion 320 of the first defining structure 300 is configured to isolate at least one layer of the light-emitting functional layer 130.

For example, as shown in Fig. 1 and Fig. 2, the first defining structure 300 is located between the pixel defining portion 230 and the base substrate 01, and between two adjacent sub-pixels 10 of different colors. For example, at least a portion of the surface of the first defining structure 300 away from the base substrate 01 is farther away from the base substrate 01 than the surface of the first electrode 110 away from the base substrate 01. For example, the first portion 310 of the first defining structure 300 is covered by the pixel defining portion 230, the orthogonal projection of the first portion 310 on the base substrate 01 falls completely within the orthogonal projection of the pixel defining portion 230 on the base substrate 01, and the area of the orthogonal projection of the first portion 310 on the base substrate 01 is smaller than the area of the orthogonal projection of the pixel defining portion 230 on the base substrate 01. The second portion 320 is located in the second opening 220, and at least one layer of the light-emitting functional layer 130 is isolated at the edge of the second portion 320 away from the first portion 310. For example, the charge-generating layer 133 of the light-emitting functional layer 130 is isolated. For example, all film layers of the light-emitting functional layer 130 are isolated. For example, a portion of isolated film layer(s) of the light-emitting functional layer 130 is located on the side wall of the second portion 320 away from the first portion 310.

As shown in Fig. 1 and Fig. 3, the minimum distance between the orthogonal projection of the support structure 400 on the base substrate 01 and the orthogonal projection of the first defining structure 300 on the base substrate 01 is a first distance L1, the minimum distance between the orthogonal projection of the support structure 400 on the base substrate 01 and the orthogonal projection of the second opening 220 on the base substrate 01 is a second distance L2, and both the first distance L1 and the second distance L2 are greater than 0 micron and less than 10 microns.

For example, as shown in Fig. 1 and Fig. 3, the support structure 400 may be located between two adjacent first openings 210, and also between two adjacent second openings 220. For example, a plurality of second openings 210 may surround the support structure 400. With the above-mentioned first distance L1 being greater than 0 micron and less than 10 microns, a portion of the pixel defining portion 230 may be enabled to be located between the support structure 400 and the first defining structure 300, so as to retain good thickness uniformity. For example, with the above-mentioned second distance L2 being greater than 0 micron and less than 10 microns, the influence on the morphology of the pixel defining portion 230 by the second opening 220 may be reduced. For example, the pixel defining portion 230 may be enabled to have thickness uniformity, so that the surface away from the base substrate 01 of the portion of the pixel defining portion 230 overlapping with the support structure 400 may have good flatness, which facilitates stable placement of the support structure 400, and reduces the risk that the support structure 400 is tilted or has its position misaligned, or any other risk.

In the display substrate in the present disclosure, on one hand, the first portion of the first defining structure overlaps with the pixel defining portion, and the second portion of the first defining structure may isolate at least one film layer of the light-emitting functional layer, so that sub-pixels may be ensured to have electrodes of good flatness and emit light with good effects, and at the same time, the risk of crosstalk between adjacent sub-pixels may be reduced; on the other hand, with the first distance between the support structure and the first defining structure and the second distance between the support structure and the second opening kept within the above-mentioned range, both the pixel defining portion and the support structure may be enabled to have good morphology, which facilitates good effect of mask supporting by the support structure and a minor impact on process and productivity.

For example, as shown in Fig. 1 and Fig. 3, both the first distance L1 and the second distance L2 are not less than 2 microns. Both the first distance L1 and the second distance L2 may be not less than 3 microns, 4 microns, 5 microns, 7 microns or 9 microns, or may be any other value between 2 microns and 10 microns, which will not be listed here in detail. With this arrangement, the influence of the second opening 220 and the defining structure 300 on the morphology of the pixel defining portion 230 may be reduced effectively, which facilitates stable arrangement of the support structure 400 and reduces the risk that the support structure 400 is tilted or has its position misaligned, or any other risk.

For example, as shown in Fig. 1 and Fig. 3, a straight-line distance between any two points on an edge of a cross section of the support structure 400 taken by a plane parallel to the base substrate 01 is not greater than 20 microns. For example, the above-mentioned straight-line distance may be the length of the straight-line segment between the two points on the edge of the above-mentioned cross section of the support structure 400. For example, the support structure 400 may have a pillar shape, and cross sections of the support structure 400 taken by a plurality of planes parallel to the base substrate 01 may have different shapes. For example, as shown in Fig. 1, the shape of the cross section of the support structure 400 taken by a plane parallel to the base substrate 01 may be a circle, and the maximum value of the straight-line distance between any two points on the edge of the above-mentioned cross section of the support structure 400 is the diameter of the circle. For example, in response to that the shape of the cross section of the support structure 400 taken by a plane parallel to the base substrate 01 is an ellipse, the maximum value of the straight-line distance between any two points on the edge of the above-mentioned cross section of the support structure 400 is the size of the major axis of the ellipse. The embodiments of the present disclosure do not limit the shape of the above-mentioned cross section corresponding to the support structure 400. For example, the shape may be polygon or any other shape.

For example, as shown in Fig. 1 and Fig. 3, in order to enable the support structure 400 to have a relatively strong capability of supporting a mask, the straight-line distance between any two points on the edge of the above-mentioned cross section of the support structure 400 may be as large as possible and may be, for example, from 10 microns to 20 microns, from 15 microns to 18 microns or from 18 microns to 19 microns, and the embodiments of the present disclosure do not limit this.

For example, as shown in Fig. 3, in the direction Z, the size of the support structure 400 is not greater than 10 microns. For example, in order to enable the support structure 400 to have a relatively strong capability of supporting a mask, the size of the support structure 400 in the direction Z may be as large as possible and may be, for example, from 5 microns to 10 microns, from 6 microns to 8 microns or from 8 microns to 10 microns, and the embodiments of the present disclosure do not limit this.

For example, as shown in Fig. 3, the support structure 400 may be formed by using a positive photoresist. For example, with a positive photoresist, the portion of the positive photoresist exposed by light undergoes degradation reaction and then can be dissolved by developing liquid, and the left unexposed portion has a shape consistent with the pattern of the mask plate.

For example, as shown in Fig. 1, the plurality of sub-pixels 10 in the display substrate include a plurality of first sub-pixels 101, a plurality of second sub-pixels 102 and a plurality of third sub-pixels 103; the plurality of sub-pixels 10 are arranged in a plurality of first sub-pixel sets 0010 and a plurality of second sub-pixel sets 0020 disposed alternately in a first arrangement direction X; the first sub-pixel set 0010 includes first sub-pixels 101 and second sub-pixels 102 disposed alternately in a second arrangement direction Y, and the second sub-pixel set 0020 includes third sub-pixels 103 arranged in the second arrangement direction Y. For example, the colors of the light emitted from the first sub-pixel 101, the second sub-pixel 102 and the third sub-pixel 103 are different from each other. For example, the first sub-pixel 101 may be a red sub-pixel that emits red light, the second sub-pixel 102 may be a blue sub-pixel that emits blue light, and the third sub-pixel 103 may be a green sub-pixel that emits green light. The embodiments of the present disclosure are not limited to this, and the colors of the light emitted from the first sub-pixel 101, the second sub-pixel 102 and the third sub-pixel 103 may be exchangeable.

For example, as shown in Fig. 1, the first sub-pixel sets 0010 and the second sub-pixel sets 0020 are distributed in a staggered manner in the second arrangement direction Y, and each of at least some of the first sub-pixels 101 is surrounded by eight sub-pixels 10, and the eight sub-pixels 10 include third sub-pixels 103 and second sub-pixels 102 disposed alternately. The first arrangement direction X intersects with the second arrangement direction Y, and both of the first arrangement direction X and the second arrangement direction Y are perpendicular to the base substrate.

For example, as shown in Fig. 1, both the area of the light-emitting region 010 of the first sub-pixel 101 and the area of the light-emitting region 010 of the third sub-pixel 103 are smaller than the area of the light-emitting region 010 of the second sub-pixel 102, and the area of the light-emitting region 010 of the third sub-pixel 103 is smaller than the area of the light-emitting region 010 of the first sub-pixel 101. For example, one second opening 220 and one first defining structure 300 (e.g., the second opening 220 and the first defining structure 300 enclosed by the dashed box P in Fig. 1) are disposed between the second sub-pixel 102 and the third sub-pixel 103. The third sub-pixel 103 is father away than the second sub-pixel 102 adjacent thereto from the second opening 220 therebetween. For example, the second opening 220 between the second sub-pixel 102 and the third sub-pixel 103 is at a distance from the light-emitting region of the third sub-pixel 103 that is not smaller than the distance between the second opening 220 and the light-emitting region of the second sub-pixel 102. For example, the distance between the first opening 210 corresponding to the third sub-pixel 103 and the second opening 220 that is between the third sub-pixel 103 and the second sub-pixel 102 is U1, the distance between the first opening 210 corresponding to the second sub-pixel 102 and the second opening 220 that is between the third sub-pixel 103 and the second sub-pixel 102 is U2, and U1 is not smaller than U2.

For example, as shown in Fig. 1, with the second opening 220 in the dashed box P taken as an example, the second opening 220 has a strip shape and, in its lengthwise direction, the second opening 220 has a length that is substantially the same as the size of the edge of the first electrode 110 (as seen in Fig. 1) of the third sub-pixel 103, and larger than the size of the light-emitting region 010 of the third sub-pixel 103, therefore, disposing the second opening 220 close to the first opening 210 corresponding to the third sub-pixel 103 may have a significant impact on the morphology of the pixel defining portion 230. For example, as a result, the portion of the pixel defining portion 230 between the first opening 210 corresponding to the third sub-pixel 103 and the second opening 220 adjacent to the first opening 210 may have a relatively small thickness, which causes this portion of the pixel defining portion 230 to fail to form a good slope angle at the first opening 210 according to design requirements, and in turn affects the light emission effect of the third sub-pixel 103.

Therefore, with the U1 being not smaller than U2 as described above, there may be enough space between the first opening corresponding to the third sub-pixel and the second opening that is between the third sub-pixel and the second sub-pixel, which facilitates disposing the pixel defining portion to enable the portion of the pixel defining portion surrounding the light-emitting region of the third sub-pixel to have good morphology. For example, a thickness large enough can be retained and a good slope angle can be formed to facilitate improvement of the light emission effect of the third sub-pixel.

For example, as shown in Fig. 1, the area of the light-emitting region of the first sub-pixel 101 is larger than the area of the light-emitting region of the third sub-pixel 103, and the second opening 220 between the first sub-pixel 101 and the third sub-pixel 103 is at a distance from the light-emitting region of the first sub-pixel 101 that is not larger than the distance between the second opening 220 and the light-emitting region of the third sub-pixel 103, so that the portion of the pixel defining portion 230 between the first opening 210 corresponding to the third sub-pixel 103 and the second opening 220 that is between the third sub-pixel 103 and the first sub-pixel 101 can have good morphology, which may enable the portion to keep a thickness large enough and form a good slope angle, so as to facilitate improvement of the light emission effect of the third sub-pixel 103.

For example, as shown in Fig. 2, the portion of the light-emitting functional layer 130 on the second portion 320 of the first defining structure 300 includes a flat portion to enable the light-emitting functional layer 130 to transition smoothly over the second portion 320, which can reduce the influence on the flatness of the portion of the light-emitting functional layer 130 in the first opening 210, and in turn ensure good light emission effect.

For example, as shown in Fig. 2, in the direction, in which the third sub-pixel 103 and the second sub-pixel 102 face each other, the maximum width M1 of the first portion 310 of the first defining structure 300 is not greater than 5 microns, for example, is from 3 microns to 5 microns. For example, the maximum width M1 of the first portion 310 may be larger than the maximum width M2 of the second portion 320, which helps to provide a coverage space large enough, and in turn facilitates formation of a good light emission angle. For example, the maximum width M2 of the second portion 320 may be from 1 micron to 10 microns and, for example, may be from 5 microns to 8 microns, but this is not limited thereto. For example, M1 ≥ M2, which helps to ensure the area of the portion of the PDL covering the first portion 310 of the first defining structure 300.

Such an arrangement facilitates good flatness of the portion of the light-emitting functional layer on the second portion, and reduces the influence on the morphology of the portion of the light-emitting functional layer in the first opening (and at the edge of the first opening) by the portion of the light-emitting functional layer that is isolated.

For example, as shown in Fig. 1, Fig. 2 and Fig. 4A, in the arrangement direction (e.g. the direction Q shown in Fig. 2) of adjacent sub-pixels 10 (e.g., the third sub-pixel 103 and the second sub-pixel 102 shown in Fig. 2), the maximum size of the cross section of the first defining structure 300 between the adjacent sub-pixels 10 that is taken by a plane is a first size M1 + M2, and the maximum size of the cross section of the first portion 310 of the first defining structure 300 that is taken by the plane is a second size M1, the second size M1 is not less than 1/2 of the first size M1 + M2, the above-mentioned plane is parallel to the arrangement direction (e.g. the direction Q) of the adjacent sub-pixels 10 and perpendicular to the base substrate 01. For example, in the embodiments of the present disclosure, the arrangement direction of the adjacent sub-pixels 10 is parallel to the base substrate 01.

For example, as shown in Fig. 1, Fig. 2 and Fig. 4A, the orthogonal projection of the first defining structure 300 on the base substrate 01 is roughly a first strip shape 3101, and the orthogonal projection of the first portion 310 of the first defining structure 300 on the base substrate 01 is roughly a second strip shape 3102. For example, the second strip shape 3102 is a portion of the first strip shape 3101. For example, the maximum width of the second strip shape 3102 is not larger than 1/2 of the maximum width of the first strip shape 3101. For example, as shown in Fig. 2, the maximum width of the second strip shape 3102 is M1, and the maximum width of the first strip shape 3101 is M1 + M2. Such a arrangement facilitates enough exposed area and in turn good isolation capability of the second portion 320 of the first defining structure 300.

For example, as shown in Fig. 2, the minimum distance M3 between the first defining structure 300 and the light-emitting region 010 of the sub-pixel 10 (e.g., the third sub-pixel 103) is not greater than 15 microns, so that the pixel defining portion 230 can retain a good slope angle µ at the first opening 210 to enable good light emission effect of the sub-pixel 10. For example, the slope angle µ of the pixel defining portion 230 at the first opening 210 may be from 20 degrees to 80 degrees, and the embodiments of the present disclosure do not limit this.

For example, as shown in Fig. 1, the length of the second opening 220 in its extending direction is not equal to the length of the first defining structure 300 in its extending direction. For example, the second opening 220 may extend along an edge of the light-emitting region 010 of an adjacent sub-pixel 10, and the first defining structure 300 may extend along an edge of the light-emitting region 010 of the adjacent sub-pixel 10. For example, the orthogonal projection of the second opening 220 on the base substrate 01 may substantially be a third strip shape 3103, and the length of the third strip shape 3103 is not equal to the length of the first strip shape 3101. For example, the length of the first strip shape 3101 is smaller than the length of the third strip shape 3103. For example, the two ends of the third strip shape 3103 along its lengthwise direction protrude from the first strip shape 3101, so that the length of the portion of the first strip shape 3101 overlapping with the third strip shape 3103 can be equal to the length of the third strip shape 3103, and in turn the second portion 320 of the first defining structure 300 used for isolating can have a uniform size. For example, the length of the first strip shape 3101 is larger than the length of the third strip shape 3103, so that the length of the portion of the first strip shape 3101 overlapping with the third strip shape 3103 can be equal to the length of the third strip shape 3103, and in turn the second portion 320 of the first defining structure 300 used for isolating can have a uniform size.

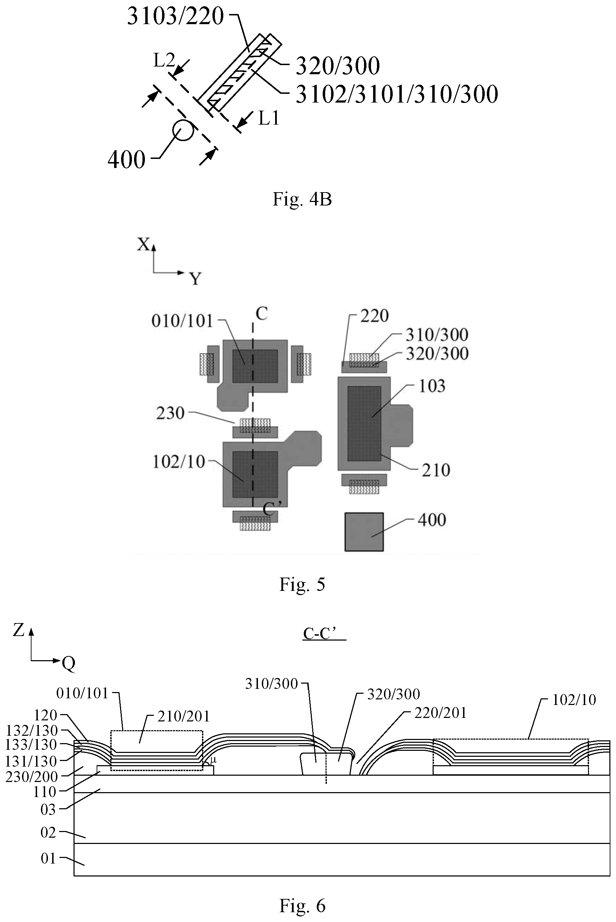

Fig. 4B is a schematic diagram of another first defining structure and a support structure provided by at least one embodiment of the present disclosure.

In some embodiments of the present disclosure, referring to Fig. 4B, the length of the second opening 220 in its extending direction may be equal to the length of the first defining structure 300 in its extending direction. For example, the length of the first strip shape 3101 is equal to the length of the third strip shape 3103, but the first distance L1 is not equal to the second distance L2. The orthogonal projection of the first portion 310 of the first defining structure 300 on the base substrate may have an "L" shape, the orthogonal projection of the second portion 320 of the first defining structure 300 on the base substrate may be the strip-shaped shadow region, and the orthogonal projection of the second opening 220 on the base substrate 01 may be the third strip shape 3103. In the lengthwise direction of the third strip shape 3103, the first defining structure 300 and the second opening 220 are staggered with each other, and the end portion of the first portion 310 of the first defining structure 300 away from the support structure 400 is located at the side of the second opening 220 away from the support structure 400. Such an arrangement facilitates control of the size of the second portion 320 (used for isolating) of the first defining structure 300 in the lengthwise direction, so that the length of the second portion 320 may be kept in a design range to achieve favorable size uniformity.

For example, as shown in Fig. 1, the length of the edge of the first defining structure 300 close to the light-emitting region 010 of the sub-pixel 10 is not greater than 50 microns. For example, the orthogonal projection of the first defining structure 300 on the base substrate may be the above-mentioned first strip shape 3101, the length of the first strip shape 3101 is not greater than 50 microns and may be, for example, from 20 microns to 30 microns, from 30 microns to 40 microns or from 35 microns to 50 microns, or may be any other value not greater than 50 microns, which will not be listed here in detail. As a result, the influence on the morphology of the pixel defining portion 230 may be reduced while the second portion 320 of the first defining structure 300 is enabled to have enough capability of isolating.

For example, as shown in Fig. 1 and Fig. 2, in the arrangement direction (e.g. the direction Q shown in Fig. 2) of adjacent sub-pixels 10 (e.g., the third sub-pixel 103 and the second sub-pixel 102 shown in Fig. 2), the maximum size, in the direction Q, of the cross section of the second opening 220 taken by a plane is not greater than 10 microns. For example, the maximum width of the third strip shape 3103 is not greater than 10 microns and, for example, may be from 5 microns to 8 microns, from 6 microns to 9 microns or from 7 microns to 10 microns, and the maximum width of the third strip shape 3103 is larger than the maximum width M2 of the second portion 320 (as seen in Fig. 2), so that the second portion 320 of the first defining structure 300 can be exposed and be enabled to have good capability of isolating.

For example, as shown in Fig. 1, the length of the second opening 220 in its extending direction is not greater than 50 microns. For example, the length of the third strip shape 3103 is not greater than 50 microns and may be, for example, from 20 microns to 30 microns, from 30 microns to 40 microns or from 35 microns to 50 microns or may be any other value not greater than 50 microns, which will not be listed here in detail. As a result, the influence on the morphology of the pixel defining portion 230 may be reduced as much as possible while the second portion 320 of the first defining structure 300 is enabled to have enough capability of isolating.

For example, as shown in Fig. 2, the distance between the first defining structure 300 and the first electrode 110 of the sub-pixel 10 (e.g., the third sub-pixel 103) is not greater than 15 microns and may be, for example, from 5 microns to 10 microns, from 7 microns to 12 microns, or from 8 microns to 13 microns, or may be any other value not greater than 15 microns, which will not be listed here in detail. With such an arrangement, the pixel defining portion 230 can be enabled to have a good slope angle µ at the first opening 210, and the path, along which the light-emitting functional layer 130 extends from the first opening 210 to the second opening 220, can be shorten, so that the fabrication process can be simplified.

For example, as shown in Fig. 1, the plurality of sub-pixels 10 are arranged in a plurality of sub-pixel rows R1 and a plurality of sub-pixel columns R2. For example, the arrangement direction of the plurality of sub-pixel rows R1 is the direction obtained by rotating the second arrangement direction Y 45 degrees clockwise, and the arrangement direction of the plurality of sub-pixel columns R2 is the direction obtained by rotating the first arrangement direction X 45 degrees clockwise. For example, there are a plurality of first defining structures 300 disposed between two adjacent sub-pixel rows R1, and the distance between two adjacent first defining structures 300 is not greater than 40 microns and may be, for example, from 5 microns to 10 microns, from 15 microns to 25 microns, or from 30 microns to 40 microns, or may be any other value not greater than 40 microns, which will not be listed here in detail. For example, there are a plurality of first defining structures 300 disposed between two adjacent sub-pixel columns R2, and the distance between two adjacent first defining structures 300 is not greater than 40 microns and may be, for example, from 5 microns to 10 microns, from 15 microns to 25 microns, or from 30 microns to 40 microns, or may be any other value not greater than 40 microns, which will not be listed here in detail. With such an arrangement, good spacing can be kept between adjacent first defining structures 300, so that a plurality of second openings 220 in the pixel defining portion 230 can be spaced from each other and distributed uniformly, and the individual portions of the pixel defining portion 230 can be enabled to keep good morphology. For example, the pixel defining portion 230 may be enabled to have thickness uniformity and form good slope angles at respective first openings 210 and second openings 220.

Fig. 5 is a schematic diagram of a partial planar structure of another display substrate provided by at least one embodiment the present disclosure. Fig. 6 is a schematic diagram of a partial cross-sectional structure taken along the line CC' shown in Fig. 5.

For example, the arrangement method of the plurality of sub-pixels in the display substrate shown in Fig. 5 is different from that in the display substrate shown in Fig. 1. As shown in Fig. 5, the plurality of sub-pixels 10 include a plurality of first sub-pixels 101, a plurality of second sub-pixels 102 and a plurality of third sub-pixels 103, and a repeating unit is constituted by a first sub-pixel 101, a second sub-pixel 102 and a third sub-pixel 103. For clarity of illustration, Fig. 5 only shows one repeating unit, but the embodiments of the present disclosure do not limit the number of repeating units. Structures such as the base substrate, the pixel defining portion and the light-emitting element in the display substrate shown in Fig. 5 may have the same features as those in the display substrate shown in Fig. 1, and will not be described here again.

For example, as shown in Fig. 5, in a repeating unit, the first sub-pixel 101 and the second sub-pixel 102 are arranged sequentially in the first arrangement direction X and located at one side of the third sub-pixel 103 in the second arrangement direction Y. The first arrangement direction X intersects with the second arrangement direction Y. For example, one of the first sub-pixel 101 and the second sub-pixel 102 may be a red sub-pixel that emits red light, while the other may be a green sub-pixel that emits green light; the third sub-pixel 103 may be a blue sub-pixel that emits blue light. For example, the colors of the light emitted from the first sub-pixel 101, the second sub-pixel 102 and the third sub-pixel 103 may be exchangeable. For example, the area of the light-emitting region of the first sub-pixel 101 is smaller than the area of the light-emitting region of the second sub-pixel 102, the area of the light-emitting region of the second sub-pixel 102 is smaller than the area of the light-emitting region of the third sub-pixel 103. Of course, the embodiments of the present disclosure are not limited to this, and the areas of the light-emitting regions of the sub-pixels may be set according to product requirements.

For example, as shown in Fig. 5, any two adjacent sub-pixels 10 among the first sub-pixel 101, the second sub-pixel 102 and the third sub-pixel 103 have one first defining structure 300 and one second opening 220 disposed therebetween. For example, two first defining structures 300 and two second openings 220 are disposed at two opposite sides respectively at any one of the first sub-pixel 101, the second sub-pixel 102 and the third sub-pixel 103.

For example, as shown in Fig. 5 and Fig. 6, the light-emitting regions 010 of adjacent sub-pixels 10 (e.g., the first sub-pixel 101 and the second sub-pixel 102) are at unequal distances from the second opening 220 between the adjacent sub-pixels 10. For example, the second opening 220 is at unequal distances from the light-emitting regions 010 of the two adjacent sub-pixels 10 at its two sides. For example, the orthogonal projection of the light-emitting region 010 of each sub-pixel 10 on the base substrate may be quadrangular, but it is not limited to this. For example, two second openings 220, which are relatively close to the light-emitting region 010 of the sub-pixel 10, are disposed at two opposite sides respectively of the sub-pixel 10, while the other two opposite sides of the sub-pixel 10 may not be provided second openings 220 thereon.

For example, as shown in Fig. 5 and Fig. 6, the second portion 320 of a first defining structure 300 is located between the first portion 310 of the first defining structure 300 and the light-emitting region 010 of one of the adjacent sub-pixels 10 that is close to the second opening 220. For example, as shown in Fig. 5, among the adjacent first sub-pixel 101 and second sub-pixel 102, the sub-pixel 10 that is close to the second opening 220 between the two sub-pixels is the second sub-pixel 102, and the second portion 320 of the first defining structure 300 is located between the first portion 310 of the first defining structure 300 and the light-emitting region 010 of the second sub-pixel 102.

For example, as shown in Fig. 5 and Fig. 6, two second openings 220 are disposed at the two opposite sides of the second sub-pixel 102 in the arrangement direction X respectively, and the one of the two second openings 220 that is between the first sub-pixel 101 and the second sub-pixel 102 is closer to the light-emitting region 010 of the second sub-pixel 102 and farther away from the light-emitting region 010 of the first sub-pixel 101. By disposing two second openings 220 at two opposite sides of the sub-pixel 10 respectively with the two second openings relatively close to the light-emitting region 010 of the sub-pixel 10, the second openings 220 may have good symmetry, so that the pixel defining portion 230 is enabled to have a good slope angle at the first opening 210, and the path, along which the light-emitting functional layer 130 extends from the first opening 210 to each second opening 220, can be shorten, which can improve the effect of isolating and facilitate simplification of the fabrication process.

For example, as shown in Fig. 5 and Fig. 6, the second portion 320 of the first defining structure 300 is located between the first portion 310 of the first defining structure 300 and the light-emitting region 010 of the sub-pixel 10 close to the second opening 220. The sub-pixel 10 close to the second opening 220 as described above refers to the sub-pixel 10 closest to the second opening 220. For example, which sub-pixel 10 is the closest sub-pixel 10 can be determined according to the distances from the second opening 220 to the first electrodes 110 of a plurality of sub-pixels 10. For example, for one of the second openings 220 disposed at two opposite sides of any sub-pixel 10, for example, the second opening 220 that is located between the first sub-pixel 101 and the second sub-pixel 102 and close to the light-emitting region 010 of the second sub-pixel 102, the second portion 320 of the first defining structure 300 overlapping with the second opening 220 is located between the first portion 310 of the first defining structure 300 and the second sub-pixel 102, that is, the second portion 320 of the first defining structure 300 used for isolating is closer to the second sub-pixel 102 than the first portion 310 of the first defining structure 300. With such an arrangement, the influence on the morphology of the pixel defining portion 230 can be reduced while the second portion 320 of the first defining structure 300 is enabled to isolate at least one layer of the light-emitting functional layer 130. For example, the portion of the pixel defining portion 230 between the second opening 220 and the first sub-pixel 101 is enabled to have good morphology, so that the influence on the light emission angle of the first sub-pixel 101 can be reduced.

For example, as shown in Fig. 5, the length of the edge of the first defining structure 300 close to the first opening 210 of the sub-pixel 10 is smaller than the length of the edge of the second opening 220 close to the first opening 210 of the sub-pixel 10, and the two ends of the second opening 220 in its extending direction protrude from the two ends of the first defining structure 300 overlapping with the second opening 220. For example, the orthogonal projection of the first defining structure 300 on the base substrate is a first strip shape, and the length of the edge of the first defining structure 300 close to the first opening 210 of the sub-pixel 10 is the length of the first strip shape. For example, the orthogonal projection of the second opening 220 on the base substrate may be a third strip shape, and the length of the edge of the second opening 220 close to the first opening 210 of the sub-pixel 10 is the length of the third strip shape. The first strip shape overlaps with the third strip shape, and the two ends of the third strip shape in the lengthwise direction of the third strip shape protrude from the first strip shape. With such an arrangement, the second portion 320 of the first defining structure 300 used for isolating is enabled to have good uniformity in size (e.g., length), thereby facilitating control of the isolating capability of the first defining structure 300.

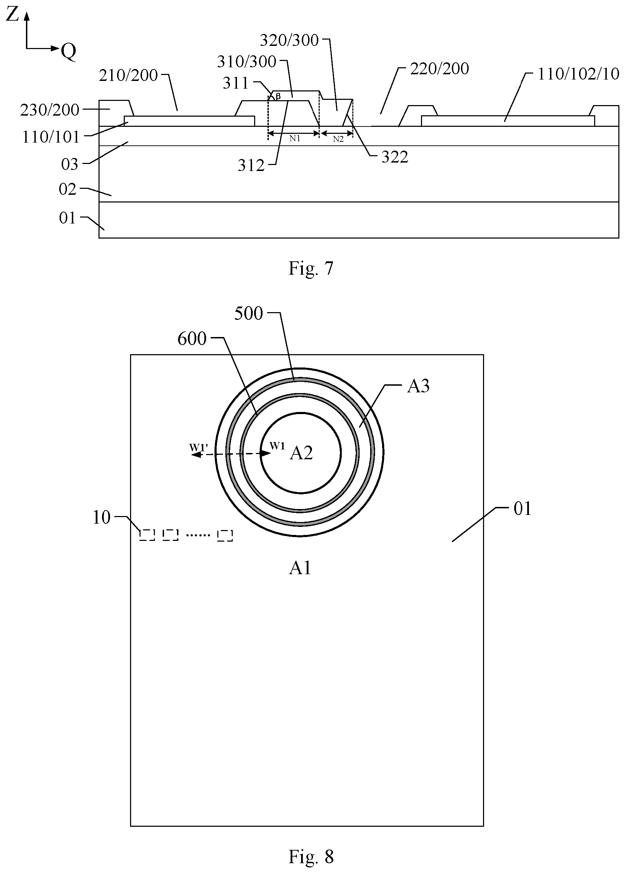

Fig. 7 is a schematic diagram of a partial cross-sectional structure of another display substrate provided by at least one embodiment of the present disclosure.

For example, in the display substrate shown in Fig. 7, the structures of the first defining structure 300 and the pixel defining portion 230 are different, and the other structures can be referred to the related description of Fig. 2 in the above embodiment.

For example, as shown in Fig. 7, the display substrate includes a base substrate 01, as well as a plurality of sub-pixels 10 and a pixel defining layer 200 located on the base substrate 01. Each of at least some of the sub-pixels 10 includes a light-emitting functional layer 130, the light-emitting functional layer 130 includes a plurality of film layers. The sub-pixel 10 further includes a first electrode 110 and a second electrode 120 on the two sides of the light-emitting functional layer 130 in a direction perpendicular to the base substrate 01, and the first electrode 110 is located between the light-emitting functional layer 130 and the base substrate 01. The light-emitting functional layer 130 may include light-emitting layers used to emit light and a charge-generating layer 133. The pixel defining layer 200 includes a plurality of first openings 210 and a plurality of second openings 220. The plurality of first openings 210 are configured to define the light-emitting regions 010 of at least some of the sub-pixels 10. At least the portion of at least one layer of the light-emitting functional layer 130 located in the first opening 210 is a continuous portion, while at least the portion of the at least one layer of the light-emitting functional layer 130 located in each of at least one second opening 220 is isolated. Referring to Fig. 2, the portion of the film layer of the light-emitting functional layer 130 located in the first opening 210 is a continuous portion, while the portion of the film layer of the light-emitting functional layer 130 located in the second opening 220 is isolated.

For example, as shown in Fig. 7, the first defining structure 300 is located between adjacent sub-pixels 10 and includes a first portion 310 overlapping with the pixel defining portion 230 and a second portion 320 exposed by the second opening 220, and the second portion 320 of the first defining structure 300 is configured to isolate at least one layer of the light-emitting functional layer 130. For example, in a direction (i.e. the direction Z) perpendicular to the base substrate 01, the average size of the first portion 310 of the first defining structure 300 is smaller than the average size of the second portion 320 of the first defining structure 300. The first portion 310 of the first defining structure 300 covers the pixel defining portion 230. A slope angle β is formed between at least a portion of the side surface 311 of the first portion 310 of the first defining structure 300 away from the second portion 320 of the first defining structure 300 and the first surface 312 of the first portion 310 close to the base substrate 01, and the angle formed between at least a portion of the side surface 311 and the portion of the first surface 312 close to the second portion 320 is less than 90 degrees and may be, for example, from 50 degrees to 70 degrees, from 60 degrees to 80 degrees or from 70 degrees to 85 degrees or may be any other angle less than 90 degrees, which will not be listed in detail, so that the slope angle β is enabled to be a "positive slope angle". For example, the side surface 311 of the first portion 310 is tilted toward the second portion 320, and enables the slope angle β to be a "positive slope angle" as described above.

With such an arrangement, in one aspect, the capability of the first portion of the first defining structure to adhere to the pixel defining portion can be improved, and the first portion is enabled to have a thickness not too small and to have good thickness uniformity; in another aspect, the second portion in the second opening is enabled to have good morphology, so that the orthogonal projection, on the base substrate, of the side surface (i.e. the side surface 322 shown in Fig. 7) of the second portion away from the first portion falls within the orthogonal projection, on the base substrate, of the surface of the second portion away from the base substrate, that is, the tilt direction of the side surface of the second portion away from the first portion is the same as the tilt direction of the side surface of the first portion away from the second portion, so as to enable the edge (e.g., the corner portion) of the second portion to have good capability of isolating.

For example, as shown in Fig. 7, in the arrangement direction (e.g. the direction Q shown in Fig. 7) of adjacent sub-pixels 10 (e.g., the first sub-pixel 101 and the second sub-pixel 102 shown in Fig. 7), the maximum size of the cross section of the first defining structure 300 between the adjacent sub-pixels 10 that is taken by a plane is a first size N1 + N2, and the maximum size of the cross section of the first portion 310 of the first defining structure 300 that is taken by the plane is a second size N1, the second size N1 is not less than 1/2 of the first size N1 + N2 and not greater than 10 microns, the above-mentioned plane is parallel to the arrangement direction (e.g. the direction Q) of the adjacent sub-pixels 10 and perpendicular to the base substrate 01.

For example, as shown in Figs. 7, the orthogonal projection of the first defining structure 300 on the base substrate 01 is roughly a first strip shape, and the orthogonal projection of the first portion 310 of the first defining structure 300 on the base substrate 01 is roughly a second strip shape; the maximum width of the first strip shape is N1 + N2, and the maximum width of the second strip shape is N1, and N1 is not less than 1/2 of N1 + N2 and not greater than 10 microns. For example, N1 is not less than N2.

With such an arrangement, the capability the first portion of the first defining structure to adhere to the pixel defining portion can be improved, the first portion is enabled to have good thickness uniformity, and the second portion is enabled to have relatively strong capability of isolating the light-emitting functional layer.

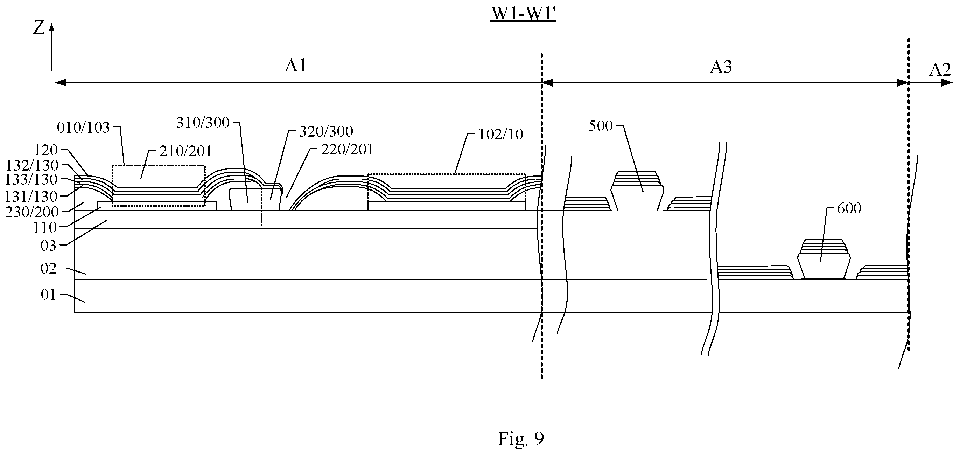

Fig. 8 is a planar diagram of yet another display substrate provided by at least one embodiment of the present disclosure. Fig. 9 is a schematic diagram of a partial cross-sectional taken along the line W1-W1' shown in Fig. 8.

For example, as shown in Fig. 8, the display substrate includes a first region A1, a second region A2 and a third region A3. The first region A1 is configured for display, and at least some of a plurality of sub-pixels 10 are located in the first region A1. For example, at least a portion of the second region A2 is configured to be light-transmitting. For example, a photo sensor, a fingerprint sensor or any other device may be disposed in the second region A2. The first region A1 is located at at least one side of the second region A2. In some embodiments, the first region A1 surrounds the second region A2, that is, the second region A2 may be surrounded by the first region A1. For example, the second region A2 may be disposed at another position, which may be determined depending on requirements. For example, the second region A2 may be located at a position in the middle at the top of the base substrate. The third region A3 is located between the first region A1 and the second region A2 and, for example, the third region A3 may serve as a transition region. For example, the structures (e.g., the first defining structure) of the base substrate described in the embodiments above may all be located in the first region A1.

For example, as shown in Fig. 8 and Fig. 9, the display substrate includes at least one second defining structure 500 located in the third region A3, and the orthogonal projection of the second defining structure 500 on the base substrate 01 is annular and surrounds the second region A2. The second defining structure 500 is configured to isolate at least one layer of the light-emitting functional layer 130. For example, the second defining structure 500 (and the third defining structure 600 in the subsequent embodiment) may increase the resistance of the second electrode, reduce the influence on the second region A2 by electrochemical corrosion, and reduce the risk that undesirable phenomena such as black spots occur in the product due to erosion by water, oxygen and the like. For example, the orthogonal projection of the second defining structure 500 on the base substrate 01 is closed annular, or non-closed annular. For example, there may be a plurality of second defining structures 500 and, for example, the number of the second defining structures 500 may be from 1 to 5 and may be, for example, in at least one range selected from the group of the range from 2 to 4, the range from 3 to 5 and the range from 1 to 2, the embodiments of the present disclosure do not limit this.

For example, as shown in Fig. 8 and Fig. 9, the material of the second defining structure 500 may be the same as that of the first defining structure 300. For example, both the first defining structure 300 and the second defining structure 500 may adopt a negative photoresist. With a negative photoresist, the portion of the photoresist exposed by light becomes insoluble substance through cross-linking reaction, while the unexposed portion is dissolved in the developing liquid, so that a formed pattern and a pattern of a mask plate are complementary. At least one film layer of the light-emitting functional layer 130 is isolated by the edge portion of the second defining structure 500 not overlapping with the pixel defining portion 230. For example, no portion of the pixel defining portion 230 is disposed in the third region A3, and at least a portion of the light-emitting functional layer 130 is disposed on the side of the second defining structure 500 away from the base substrate 01, and isolated by the second defining structure 500. For example, both the edge of the second defining structure 500 close to the first region A1 and the edge of the second defining structure 500 close to the second region A2 are configured to isolate at least one layer of the light-emitting functional layer 130, so that the risk of crosstalk can be further reduced.

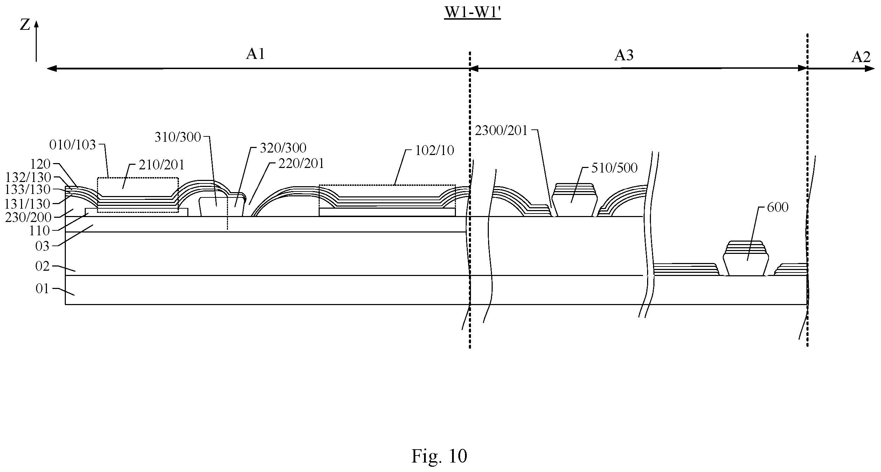

Fig. 10 is a schematic diagram of a partial cross-sectional of yet another display substrate provided by at least one embodiment of the present disclosure.

For example, the display substrate shown in Fig. 10 is different from the display substrate shown in Fig. 9 in that a portion of the pixel defining portion 230 is further disposed in the third region A3. Other structures remain the same, and the related description in the above-described embodiments can be referred to for details, which will be not repeated here.

For example, as shown in Fig. 10, the plurality of openings 201 in the pixel defining layer 200 include a third opening 2300, the third opening 2300 is located in the third region A3 and is configured to expose at least a portion of the second defining structure 500. For example, the display substrate includes at least one second defining structure 500, and the at least one second defining structure 500 includes a first sub-defining structure 510. The first sub-defining structure 510 is exposed completely by the third opening 2300, so that both the edge of the first sub-defining structure 510 close to the first region A1 and the edge of the first sub-defining structure 510 close to the second region A2 can isolate at least one layer of the light-emitting functional layer 130, thereby reducing the risk of crosstalk. Furthermore, since a portion of the pixel defining section 230 is located in the third area A3, the portion of the pixel defining section 230 located in the first area A1 may be enabled to transition to the portion of the pixel defining portion 230 located in the third region A3, so that the electrode flatness of the sub-pixel can be ensured and good light emission effect can be achieved.

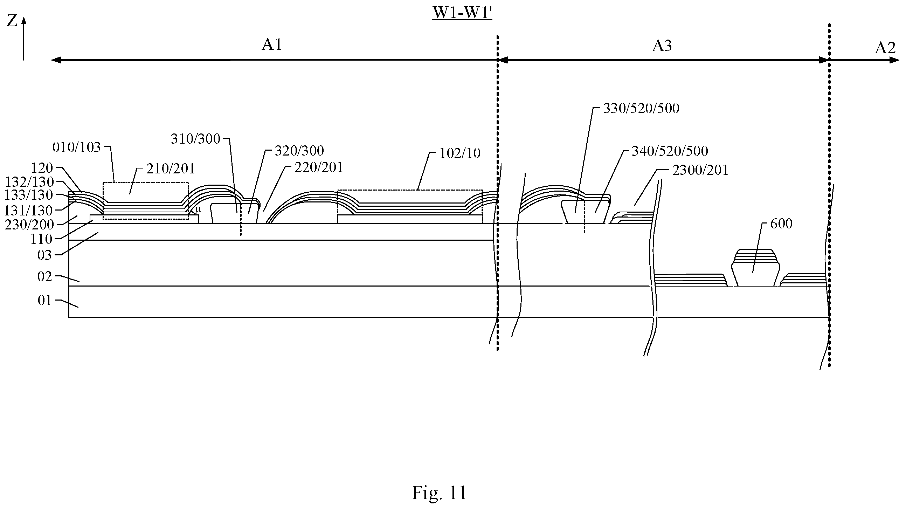

Fig. 11 is schematic diagram of a partial cross-sectional of yet another display substrate provided by at least one embodiment of the present disclosure.

For example, the display substrate shown in Fig. 11 is different from the display substrate shown in Fig. 10 in that the portion of the pixel defining portion 230 in the third region A3 is different. Other structures remain the same and the related description in the above-described embodiments can be referred to for details, which will not be repeated here.

For example, as shown in Fig. 11, the plurality of openings 201 in the pixel defining layer 200 include a third opening 2300, the third opening 2300 is located in the third region A3, and the display substrate includes at least one second defining structure 500. The at least one second defining structure 500 includes a second sub-defining structure 520. The second sub-defining structure 520 includes a third portion 330 overlapping with the pixel defining portion 230 and a fourth portion 340 exposed by the third opening 2300. The fourth portion 340 of the second sub-defining structure 520 is configured to isolate at least one layer of the light-emitting functional layer 130.

For example, as shown in Fig. 11, a portion of the pixel defining portion 230 may be located in a portion of the third region A3 close to the first region A1, and the third portion 330 of the second sub-defining structure 520 is covered by the portion of the pixel defining portion 230, so that electrode flatness of the sub-pixel 10 in the first region A1 can be ensured and good light emission effect can be achieved. For example, the edge of the fourth portion 340 of the second sub-defining structure 520 away from the third portion 330 of the second sub-defining structure 520 is configured to isolate at least one layer of the light-emitting functional layer 130, so that the risk of crosstalk can be reduced. For example, in response to only one second sub-defining structure 520 is disposed in the third region A3, there is no portion of the pixel defining portion 230 disposed at the side of the third portion 330 of the second sub-defining structure 520 away from the first region A1, so that the fabrication process can be simplified.

For example, in some embodiments, referring to Fig. 11, the display substrate includes at least one second defining structure 500, and the at least one second defining structure 500 includes at least one first sub-defining structure 510 and at least one second sub-defining structure 520. For example, the first sub-defining structure 510 is closer to the second region A2 than the second sub-defining structure 520. For example, there may be one second sub-defining structure 520, so that the electrode of the sub-pixel 10 in the first region A1 may have flatness through the portion of the pixel defining portion 230 covering the third portion 330 of the second sub-defining structure 520, so as to achieve good light emission effect. For example, the fourth portion 540 of the second sub-defining structure 520 and the at least one first sub-defining structure 510 are all exposed by the third opening 2300, so that the fourth portion 540 of the second sub-defining structure 520 and the at least one first sub-defining structure 510 function together to isolate at least one layer of the light-emitting functional layer 130, so as to reduce the risk of crosstalk and simplify the fabrication process.

For example, as shown in Fig. 11, the display substrate further includes a third defining structure 600, the third defining structure 600 is located in the third region A3 and between the second defining structure 500 and the second region A2. The pixel defining portion 230 is located at the side of the third defining structure 600 away from the second region A2, and the third defining structure 600 is configured to isolate at least one film layer of the light-emitting functional layer 130. For example, the third defining structure 600 is closer to the base substrate 01 than the second defining structure 500. For example, the structure of the third defining structure 600 is similar to that of the first sub-defining structure 510 described in the embodiments above, and may isolate at least one layer of the light-emitting functional layer 130 to further reduce the risk of crosstalk.

For example, as shown in Fig. 11, at least one of the first defining structure 300, the second defining structure 500 and the third defining structure 600 has the edge of its surface away from the base substrate 01 protrudes the edge of its surface close to the base substrate 01. For example, the surface away from the base substrate 01 of at least one of the first defining structure 300, the second defining structure 500 and the third defining structure 600 has a portion parallel to the base substrate, and the edge of this surface protrudes the edge of the surface close to the base substrate 01 of the at least one of the first defining structure 300, the second defining structure 500 and the third defining structure 600. For example, such an arrangement may facilitate formation of an "undercut" structure, which is beneficial for isolating at least one layer of the light-emitting functional layer 130. For example, the cross section of at least one of the first defining structure 300, the second defining structure 500 and the third defining structure 600 that is taken by a plane parallel to the arrangement direction of two adjacent sub-pixels 10 of different colors (e.g., the third sub-pixel 103 and the second sub-pixel 102 show in Fig. 11) and perpendicular to the base substrate 01 is trapezoidal. For example, the first defining structure 300, the second defining structure 500 and the third defining structure 600 may adopt the same material and, for example, may all adopt a negative photoresist, and the embodiments of the present disclosure do not limit this. For example, the first defining structure 300, the second defining structure 500 and the third defining structure 600 may be fabricated through the same process, so that the process flow may be simplified. In some embodiments, the first defining structures 300, the second defining structure 500 and the third defining structure 600 may have structures different from each other and, for example, may have sizes different from each other in the direction Z, the embodiments of the present disclosure do not limit this.

Another embodiment of the present disclosure provides a display panel, which includes any one of the display substrates described above. Thereby, the technical effect of the above-described display substrates may also be embodied by the display panel and will not be described again. For example, the display panel may further include an enhance efficiency structure (EES) on the display substrate (e.g., on its package layer) to enhance the light emission efficiency. For example, the display panel may also include color filters. The color filters may be located, for example, at the side of the EES away from the display substrate, but this is not limiting. The color densities of light rays can be enhanced by the color filters. For example, the display panel may also be provided with other film layers, and the embodiments of the present disclosure do not limit this.

Yet another embodiment of the present disclosure provides a display device including any of the display substrates described above. Thereby, the technical effects of the above-described display substrates may also be embodied by the display device and will not be described again.

For example, the display device may also include a cover plate located at the light emission side of the display substrate.

For example, the display device may be an organic light-emitting diode display device and may also be any product or component including the display apparatus and with a display function, such as television, a digital camera, a mobile phone, a watch, a tablet computer, a laptop computer, a navigation instrument, or the like, which is not limited in the present embodiment.

The Tandem technology is to stack and connect in series the sub-pixel light-emitting layers, and provide a whole charge-generating layer between the stacked light-emitting layers, such as a P-type doped charge-generating layer P-CGL and an N-type doped charge-generating layer N-CGL. Compared with the display substrate without the Tandem device, the Tandem device uses an N/P-CGL as a heterojunction to connect two light-emitting layers in series. This technology in order connects in series two light-emitting devices, and under the same luminous intensity, greatly reduces the luminous current of light-emitting devices, improves the life of organic light-emitting devices, and reduces power consumption.

During the research, the inventor of the present application found that on the one hand, the Tandem device adopts stacked light-emitting layers, which puts forward higher requirements for materials and evaporation; and on the other hand, because of the high conductivity of the charge-generating layer in the Tandem device, for example, when the charge-generating layer is a whole surface film layer, the charge-generating layer of adjacent two sub-pixels is a continuous film and may have a phenomenon of charge transverse migration, which leads to low-grayscale monochromatic chromaticity shift of the display substrate, such as crosstalk between adjacent sub-pixels, resulting in the color shift of the display substrate. For example, the charge-generating layer may easily lead to crosstalk between sub-pixels of different colors at low brightness, which further leads to low-grayscale color shift.

Embodiments of the present disclosure provide a display substrate and a display device. The display substrate includes a base substrate, a plurality of sub-pixels, a pixel-defining pattern, and a defining structure located on the base substrate. Each sub-pixel in at least some of the sub-pixels includes a light-emitting functional layer, and the light-emitting functional layer includes a plurality of film layers. The pixel-defining pattern includes a plurality of openings and a pixel-defining portion surrounding the plurality of openings, and at least part of at least one layer of the light-emitting functional layer is isolated in at least one opening; the defining structure is located between the pixel-defining portion and the base substrate. The defining structure is located between the pixel-defining portion and the base substrate. The defining structure is at least located between two adjacent sub-pixels of different colors, and the defining structure includes a first portion covered by the pixel-defining portion and a second portion exposed by the opening, and the second portion of the defining structure is configured to isolate the at least one layer of the light-emitting functional layer. A material of the defining structure includes an organic material, and an orthogonal projection of an edge of, a side surface of the second portion of the defining structure, away from the base substrate on the base substrate falls into an orthogonal projection of the opening on the base substrate.

The first portion of the defining structure made of the organic material provided in the present disclosure is covered by the pixel-defining portion, and the second portion is exposed by at least one opening, and at the same time, the orthogonal projection of the edge of, the side surface of the second portion of the defining structure, away from the base substrate on the base substrate falls into the orthogonal projection of the opening on the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structure on the process and throughput.

The display substrate and display device provided in the embodiments of the present disclosure are described below with reference to the accompanying drawings.

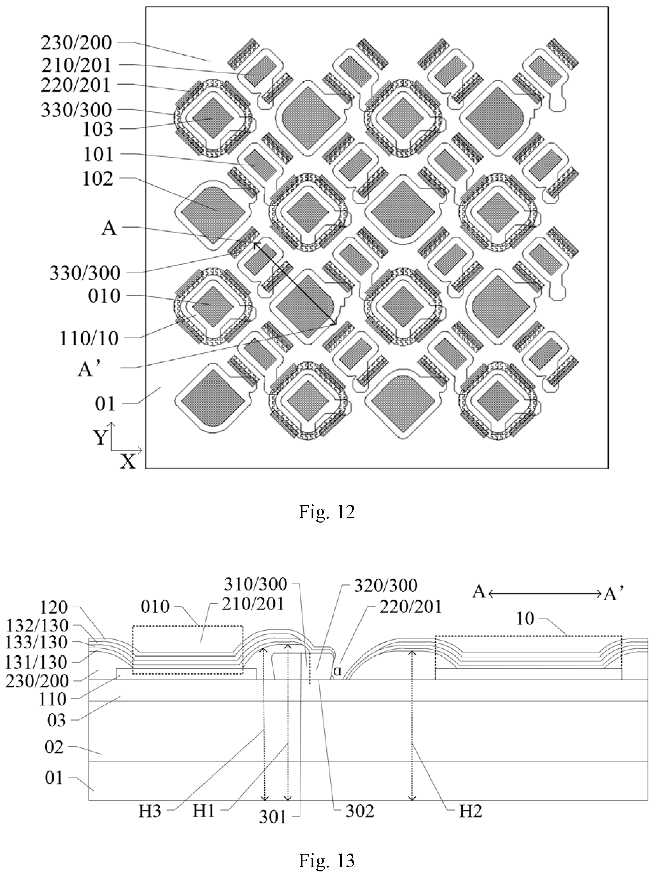

Fig. 12 is a schematic diagram of a partial planar structure provided according to an example of an embodiment of the present disclosure. Fig. 13 is a schematic diagram of a partial cross-sectional structure taken along the AA' line shown in Fig. 12.

As shown in Fig. 12 and Fig. 13, the display substrate includes a base substrate 01, a plurality of sub-pixels 10, a pixel-defining pattern 200 and a defining structure 300 located on the base substrate 01. Each sub-pixel 10 in at least part of the sub-pixels 10 includes a light-emitting functional layer 130, and the light-emitting functional layer 130 includes a plurality of film layers. For example, at least part of the sub-pixels 10 above is located in a display region of the display substrate, that is, a region used to display an image, and the display substrate further includes a peripheral region surrounding the display region.

For example, as shown in Fig. 13, the sub-pixel 10 further includes a first electrode 110 and a second electrode 120 located on both sides of the light-emitting functional layer 130 in a direction perpendicular to the base substrate 01 (for example, in a direction perpendicular to the direction of the XY plane as shown in Fig. 12), and the first electrode 110 is located between the light-emitting functional layer 130 and the base substrate 01.

For example, as shown in Fig. 13, the light-emitting functional layer 130 may include a light-emitting layer for emitting light as well as a charge-generating layer 133. For example, the light-emitting functional layer 130 may be a film in an organic light-emitting element. For example, the light-emitting functional layer 130 may include a first light-emitting layer (EML) 131, a charge-generating layer (CGL) 133 and a second light-emitting layer (EML) 132 arranged in a stacked manner, and the charge-generating layer 133 is located between the first light-emitting layer 131 and the second light-emitting layer 132. The thickness of the plurality of layers included in the light-emitting functional layer 130 shown in Fig. 13 is merely for a clear illustration of each layer and does not represent the actual size.

For example, as shown in Fig. 13, the charge-generating layer 133 has strong electrical conductivity, which provides the light-emitting functional layer 130 with advantages of long service life, low power consumption, and high brightness. For example, the same sub-pixel 10 may include a tandem light-emitting element, such as the Tandem OLED. Of course, the embodiments of the present disclosure are not limited thereto, and the light-emitting functional layer 130 of each sub-pixel 10 may also include only one light-emitting layer.

For example, as shown in Fig. 13, in the same sub-pixel 10, the first light-emitting layer 131 and the second light-emitting layer 132 can be light-emitting layers that emit light of the same color. For example, the first light-emitting layers 131 in sub-pixels 10 that emit light of different colors emit light of different colors. For example, the second light-emitting layers 132 in sub-pixels 10 that emit light of different colors emit light of different colors. Of course, the embodiments of the present disclosure are not limited thereto. For example, in the same sub-pixel 10, the first light-emitting layer 131 and the second light-emitting layer 132 can be light-emitting layers emitting different colors of light. Providing the light-emitting layers emitting light of different colors in the same sub-pixel 10 can mix the light emitted by the plurality of light-emitting layers included in the sub-pixel 10 into white light, and the color of the light emitted from each sub-pixel 10 can be adjusted by providing a color film layer.

For example, in each sub-pixel 10, the light-emitting functional layer 130 can also include a hole injection layer (HIL), a hole transport layer (HTL), an electron transport layer (ETL), and an electron injection layer (EIL).

For example, the hole injection layer, the hole transport layer, the electron transport layer, the electron injection layer, the charge-generating layer 133 and the second electrode 120 are all shared film layers of the plurality of sub-pixels 10, which can be called common layers.

For example, as shown in Fig. 13, the second light-emitting layer 132 can be located between the first light-emitting layer 131 and the second electrode 120, and the hole injection layer can be located between the first electrode 110 and the first light-emitting layer 131. For example, an electron transport layer can also be provided between the charge-generating layer 133 and the first light-emitting layer 131. For example, a hole transport layer may be provided between the second light-emitting layer 132 and the charge-generating layer 133. For example, an electron transport layer and an electron injection layer may be provided between the second light-emitting layer 132 and the second electrode 120.

For example, the charge-generating layer 133 may include an N-type charge-generating layer and a P-type charge-generating layer.

For example, the material of the electron transport layer may include aromatic heterocyclic compounds, e.g., imidazole derivatives such as benzimidazole derivatives, imidazopyridine derivatives, benzimidazole phenanthridine derivatives, etc.; zine derivatives such as pyrimidine derivatives, triazine derivatives, etc.; compounds containing a nitrogen-containing six-membered ring structure such as quinoline derivatives, isoquinoline derivatives, phenanthroline derivatives, etc. (compounds with phosphine oxide substituents on a heterocyclic ring are also included), or the like.

For example, the charge-generating layer 133 may be made of a material that is either a material containing a phosphorus group or a material containing triazine.

For example, the ratio of the electron mobility of the material of the charge-generating layer 133 to the electron mobility of the electron transport layer is 10⁻² to 10².

For example, the first electrode 110 may be an anode, and the second electrode 120 may be a cathode. For example, the cathode may be formed from a material with high conductivity and a low work function, for example, the cathode may be made of a metal material. For example, the anode may be formed from a transparent conductive material with a high work function.

For example, Fig. 13 schematically shows the spacing being provided between the light-emitting layers of different sub-pixels 10. For example, the area of the orthogonal projection of the charge-generating layer 133 on the base substrate 01 is greater than the area of the orthogonal projection of any light-emitting layer on the base substrate 01.

For example, as shown in Fig. 13, other structures 02 are further disposed on a side of the first electrode 110 facing the base substrate 01, such as a pixel circuit electrically connected with the first electrode 110 of the sub-pixel 10, a signal line and respective insulating layers, such as a passivation layer, a buffer layer, a gate insulating layer, an interlayer insulating layer, and the like.

As shown in Fig. 12 and Fig. 13, the pixel-defining pattern 200 includes a plurality of openings 201 and a pixel-defining portion 230 surrounding the plurality of openings 201, and at least part of at least one layer of the light-emitting functional layer 130 is isolated in the at least one of the openings 201.

In some examples, as shown in Fig. 12 and Fig. 13, the plurality of openings 201 includes a plurality of first openings 210 and a plurality of second openings 220, the plurality of first openings 210 is configured to define light-emitting regions 010 of at least part of the sub-pixels 10, and at least part of at least one layer of the light-emitting functional layer 130 in the first opening 210 is a continuous part, and at least a part of at least one layer of the light-emitting functional layer 130 in at least one of the second openings is partially isolated. As schematically shown in Fig. 12 and Fig. 13, a part of the film layer of the light functional layer 130 in the first opening 210 is a continuous portion, and the part in the second opening 220 is isolated.

For example, as shown in Fig. 12 and Fig. 13, one sub-pixel 10 corresponds to at least one first opening 210, at least part of the light-emitting functional layer 130 of the sub-pixel 10 is located in the first opening 210 corresponding to the sub-pixel 10, and the first opening 210 is configured to expose the first electrode 110. Fig. 12 shows only the light-emitting region 010 and the first electrode 110 of the sub-pixel, but does not show the second electrode 120, and the second electrode 120 can be a continuously arranged film at least outside the second opening 220.

For example, as shown in Fig. 13, when the light-emitting functional layer 130 is formed in the first opening 210 of the pixel-defining pattern 200, the first electrode 110 and the second electrode 120 located on both sides of the light-emitting functional layer 130 can drive the light-emitting functional layer 130 in the first opening 210 to emit light. For example, the first opening 210 of the pixel-defining pattern 200 is used to define the light-emitting region 010 of the sub-pixel 10. The light-emitting region 010 above may refer to the effective light-emitting region of the sub-pixel 10, and the shape of the light-emitting region 010 refers to a two-dimensional shape, for example, the shape of the light-emitting region 010 may be the same as the shape of the first opening 210 of the pixel-defining pattern 200.

For example, as shown in Fig. 13, the pixel-defining portion 230 may be made of materials including polyimide, acrylic, or polyethylene terephthalate, etc.

As shown in Fig. 12 and Fig. 13, the defining structure 300 is at least located between two adjacent sub-pixels 10 of different colors, and the defining structure 300 includes a first portion 310 covered by the pixel-defining portion 230 and a second portion 230 exposed by the opening 201, and the second portion 320 of the defining structure 300 is configured to isolate at least one layer of the light-emitting functional layer 130.

In some examples, as shown in Fig. 12 and Fig. 13, the defining structure 300 is located between the pixel-defining portion 230 and the base substrate 01, the defining structure 300 is at least located between two adjacent sub-pixels 10 of different colors, the defining structure 300 includes the first portion 310 covered by the pixel-defining portion 230 and the second portion 320 exposed by at least one of the first opening 210 and the second opening 220, and the second portion 320 of the defining structure 300 is configured to isolate at least one layer of the light-emitting functional layer 130, such as the charge-generating layer in the light-emitting functional layer 130, such as all the film layers in the light-emitting functional layer.

For example, as shown in Fig. 12 and Fig. 13, the orthogonal projection of the first portion 310 of the defining structure 300 on the base substrate 01 overlaps with the orthogonal projection of the pixel-defining portion 230 on the base substrate 01, and the orthogonal projection of the second portion 320 of the defining structure 300 on the base substrate 01 does not overlap with the orthogonal projection of the pixel-defining portion 230 on the base substrate 01. For example, the defining structure 300 includes two edges, one edge is an edge of the first portion 310, the other edge is an edge of the second portion 320, the edge of the first portion 310 is enclosed by the pixel-defining portion 230, and the edge of the second portion 320 is exposed by at least one of the first opening 210 and the second opening 220.

Fig. 12 and Fig. 13 schematically show that the second portion 320 of the defining structure 300 is exposed by the second opening 220 of the pixel-defining pattern 200. For example, as shown in Fig. 13, in the direction parallel to the base substrate 01, there is a certain gap between the edge of the defining structure 300 exposed by the second opening 220 and the pixel-defining portion 230, which includes a film layer which is isolated in the light-emitting functional layer 130.

As shown in Fig. 13, a material of the defining structure 300 includes an organic material, and an orthogonal projection of an edge of, a side surface of the second portion 320 of the defining structure 300, away from the base substrate 01 on the base substrate 01 falls into an orthogonal projection of the opening 201 on the base substrate 01.

For example, as shown in Fig. 13, an angle α between the side surface of the second portion 320 of the defining structure 300 and a plane where a surface of the defining structure 300 close to the base substrate 01 is located is greater than 20 degrees and less than 90 degrees. The angle between the side surface of the defining structure 300 and the plane above refers to an acute angle.

The first portion of the defining structure made of the organic material provided in the present disclosure is covered by the pixel-defining portion, and the second portion is exposed by at least one of the first opening and the second opening, and at the same time, the orthogonal projection of the edge of, the side surface of the second portion of the defining structure, away from the base substrate on the base substrate falls into the orthogonal projection of the opening on the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structure on the process and throughput.

Compared with the greater impact of the defining structure made of the inorganic material on the production capacity of the display substrate in the manufacturing process, the defining structure made of the organic material provided in the present disclosure can be formed after the first electrode of the sub-pixel, or in the case that the defining structure does not overlap with the first electrode of the sub-pixel, the defining structure is formed before the first electrode is formed, which will not affect the flatness of the first electrode, minimizing the impact on the process and production capacity. For example, the pixel-defining pattern is patterned after the first electrode and the defining structure are formed.

For example, as shown in Fig. 13, an angle α between a side surface of the second portion 320 of the defining structure 300 and a plane where a surface of the defining structure 300 away from the base substrate 01 is located is greater than 20 degrees and less than 90 degrees. For example, a connection between a side surface of the second portion 320 of the defining structure 300 and a surface of the defining structure 300 away from the base substrate 01 may be a round corner, and angle between the two surfaces may be α.

For example, as shown in Fig. 13, the angle α may be 30 degrees to 70 degrees. For example, the angle α may be 30 degrees to 60 degrees. For example, the angle α may be 25 degrees to 45 degrees. For example, the angle α may be 35 degrees to 60 degrees. For example, the angle α may be 45 degrees to 80 degrees. For example, the angle α may be 65 degrees to 80 degrees. For example, the angle α may be 71 degrees to 75 degrees.

For example, as shown in Fig. 12 and Fig. 13, the defining structure 300 may be made of a material of organic adhesive.

In some examples, as shown in Fig. 12 and Fig. 13, the cross-section of the defining structure 300 taken along the plane parallel to the arrangement direction of two adjacent sub-pixels 10 of different colors and perpendicular to the base substrate 01 is in a trapezoidal shape. For example, the above plane may be a plane parallel to a line AA' and perpendicular to a plane XY. For example, the above plane may be a plane perpendicular to the extension direction of the defining structure 300.

In some examples, as shown in Fig. 12 and Fig. 13, the length of a first base edge 301 of the trapezoid away from of the base substrate 01 is greater than the length of a second base edge 302 of the trapezoidal close to the base substrate 01. The angle between the first base edge 301 and the trapezoidal waist is greater than 20 degrees and less than 90 degrees, and the lengths of the first base edge 301 and the second base edge 302 are not greater than 10 microns.

Providing a defining structure of a structure with a trapezoidal cross-section may facilitate disconnecting at least one layer of the light-emitting functional layer and preventing crosstalk between two adjacent sub-pixels of different colors.

For example, as shown in Fig. 13, the lengths of the first base edge 301 and the second base edge 302 are not greater than 10 microns. For example, the lengths of the first base edge 301 and the second base edge 302 are not greater than 1 micron. For example, the lengths of the first base edge 301 and the second base edge 302 are not greater than 2 microns. For example, the length of the first base edge 301 is greater than 5 microns. For example, the length of the second base edge 302 is less than 8 microns. For example, the lengths of the first base edge 301 and the second base edge 302 are not greater than 3 microns. In the embodiments of the present disclosure, the first base edge 301 and the second base edge 302 may be any numerical value between greater than 0 and less than 10 microns, which will not be enumerated again herein.

In some examples, as shown in Fig. 13, the thickness of the defining structure 300 is not greater than 5 microns, and the edge of the surface of the second portion 320 of the defining structure 300 away from the base substrate 01 protrudes relative to the edge of the surface of the defining structure close to the base substrate 01 by a size not greater than 5 microns.

For example, as shown in Fig. 13, in the extension direction of the AA' line, the surface of the second portion 320 of the defining structure 300 away from the base substrate 01 protrudes relative to the surface of the second portion of the defining structure close to the base substrate 01 by a size not greater than 5 microns. For example, the surface of the second portion 320 of the defining structure 300 away from the base substrate 01 is the upper surface, and the surface of the second portion 320 of the defining structure 300 close to the base substrate 01 is the lower surface, and the edge of the upper surface may protrude relative to the edge of the lower surface by 1 micron, or 2 microns, or 3 microns, or 4 microns. The edge of the upper surface may protrude relative to the edge of the lower surface by any size of any numerical value between greater than 0 and less than 5 microns in the embodiments of the present disclosure, which will not be enumerated again herein.

In some examples, as shown in Fig. 13, the angle between a side surface of the second portion 320 of the defining structure 300 and the plane where the first surface of the defining structure 300 close to the base substrate 01 is located (such as the surface where the first base edge 301 of the cross-section is located) is greater than 20 degrees and less than 90 degrees. The orthogonal projection of the first surface on the base substrate 01 falls into the orthogonal projection of the second surface of the second portion 320 away from the base substrate 01 (such as the surface where the second base edge 302 of the cross-section is located) on the base substrate 01, and the distance between the orthogonal projection of the edge of the first surface and the orthogonal projection of the edge of the second surface is not greater than 5 microns. For example, the distance between the orthogonal projection of the edge of the first surface and the orthogonal projection of the edge of the second surface is not greater than 4 microns, or not greater than 3 microns, or not greater than 2 microns, or the like, and the distance between the orthotropic projection of the edge of the first surface and the orthogonal projection of the edge of the second surface may be any numerical value between greater than 0 and less than 5 microns, which will not be enumerated again here.

For example, as shown in Fig. 13, the thickness of the defining structure 300 is greater than 1 micron. For example, the thickness of the defining structure 300 may be 1.5 microns to 2 microns. For example, the thickness of the defining structure 300 is not greater than 4.5 microns. For example, the thickness of the defining structure 300 is not greater than 4 microns. For example, the thickness of the defining structure 300 is not greater than 3.5 microns. For example, the thickness of the defining structure 300 is not greater than 3 microns. For example, the thickness of the defining structure 300 is not greater than 2.5 microns. The thickness of the defining structure 300 provided in an embodiment of the present disclosure may be any numerical value greater than 0 and less than 5 microns, which will not be enumerated again herein.

In some examples, as shown in Fig. 13, the thickness of the defining structure 300 is greater than that of the first electrode 110, and the thickness of at least part of the pixel-defining portion 230 that does not overlap with the defining structure 300 in the direction perpendicular to the base substrate 01 is greater than the thickness of the defining structure 300. By setting the thickness relationship between the defining structure 300, the first electrode 110 and the pixel-defining portion 230, at least one layer of the light-emitting function layer 130 of adjacent sub-pixels of different colors may be isolated to reduce crosstalk without affecting the normal luminous state of the sub-pixels.

For example, as shown in Fig. 13, the distance between a surface of the pixel-defining portion 230 away from the base substrate 01 and the base substrate 01 at an overlapping position between the pixel-defining portion 230 and the defining structure 230 is H1, and the distance between the surface of the pixel-defining portion 230 away from the base substrate 01 and the base substrate 01 at a position not overlapping between the pixel-defining portion 230 and the defining structure 300 is H2 or H3, and both H2 and H3 are less than H1. For example, the difference between H1 and H2 is no greater than 5 microns. For example, the difference between H1 and H3 is no greater than 5 microns.

For example, as shown in Fig. 13, the thickness of the pixel-defining portion 230 at the overlapping position between the pixel-defining portion 230 and the defining structure 230 may be 2 microns to 3 microns, such as 2.5 microns to 2.8 microns, and 2.735 microns. For example, the thickness of the pixel-defining portion 230 may be 1.1 microns to 1.5 microns, such as 1.217 microns, and the thickness of the defining structure 300 may be 1.3 microns to 1.7 microns, such as 1.518 microns.

In some examples, as shown in Fig. 12 and Fig. 13, the orthogonal projection of the defining structure 300 on the base substrate 01 does not overlap with the orthogonal projection of the first opening 210 on the base substrate 01, and the second opening 220 exposes the second portion 320 of the defining structure 300. For example, the defining structure 300 is only exposed by the second opening 220 of the pixel-defining pattern 200, and the second portion 320 of the defining structure 300 exposed by the second opening 220 isolates at least one layer of the light-emitting functional layer 130, such as a charge-generating layer, or the charge-generating layer and all the layers between the charge-generating layer and the base substrate 01, such as all the film layers in the light-emitting functional layers 130. For example, the second electrode 120 is isolated at the edge of the defining structure 300 exposed by the second opening 220.

For example, as shown in Fig. 13, the portion of the defining structure 300 that is not covered by the pixel-defining portion 230, such as the surface of the second portion 320 away from the base substrate 01, extends in the direction of line AA' by a distance of not greater than 10 microns.

In some examples, as shown in Fig. 12 and Fig. 13, an insulating layer 03 is further provided between the first electrode 110 and the base substrate 01, the first electrode 110 and the defining structure 300 are both in contact with the insulating layer 03, the defining structure 300 and the first electrode 110 are spaced apart, and the distance between the defining structure 300 and the first electrode 110 closest to it is not greater than 10 microns. The first electrode 110 closest to the defining structure 300 refers to the defining structure 300 and the first electrode 110 both covered by the pixel-defining portion 230 located between the first opening 210 and the second opening 220. The distance between the defining structure 300 and the first electrode 110 closest to it refers to the distance between the bottom edge of one side of the defining structure 300 close to the base substrate 01 and the first electrode 110. While spacing the defining structure 300 and the first electrode 110 apart, the distance between the first electrode 110 and the defining structure 300 needs to be considered to ensure that the defining structure 300 does not cause an impact on the light emitting effect of the sub-pixel 10.

For example, as shown in Fig. 13, the insulating layer 03 may be a planarization layer.

For example, as shown in Fig. 13, the distance between the defining structure 300 and the first electrode 110 is greater than 1 micron. For example, the distance between the defining structure 300 and the first electrode 110 is not greater than 9 microns. For example, the distance between the defining structure 300 and the first electrode 110 may be 2 microns to 8 microns. In the embodiments of the present disclosure, the distance between the defining structure 300 and the first electrode 110 may be any values greater than 0 microns and less than 10 microns, which will not be enumerated again herein.

For example, as shown in Fig. 13, when defining structure 300 and the first electrode 110 are spaced apart, the first electrode 110 can be patterned first, and then the defining structure 300 can be patterned to prevent affecting the flatness of the first electrode 110. It is also possible to first pattern to form the defining structure 300, and then pattern to form the first electrode 110 to ensure the outline of the first opening 210 of the pixel-defining pattern 200.

In some examples, as shown in Fig. 12 and Fig. 13, the part of the defining structure 300 between two adjacent sub-pixels 10 of different colors includes at least one sub-defining structure 330. For example, the defining structure 300 includes a plurality of sub-defining structures 330, and at least one sub-defining structure 330 is arranged between two adjacent sub-pixels 10 of different colors. The display substrate in Fig. 12 schematically shows that there is one sub-defining structure 330 provided between two adjacent sub-pixels 10 of different colors.

In some examples, as shown in Fig. 12, two adjacent sub-pixels 10 of different colors include a first color sub-pixel 101 and a second color sub-pixel 102.

In some examples, as shown in Fig. 12, the first color sub-pixel 101 includes a red sub-pixel or a green sub-pixel, and the second color sub-pixel 102 includes a blue sub-pixel. For example, Fig. 12 schematically shows that the first color sub-pixel 101 is the green sub-pixel and the second color sub-pixel 102 is the blue sub-pixel. For example, the plurality of sub-pixels 10 further includes a third color sub-pixel 103, and the third color sub-pixel 103 is the red sub-pixel. The embodiments of the present disclosure are not limited thereto, and the colors of the first color sub-pixel 101, the second color sub-pixel 102 and the third color sub-pixel 103 are interchangeable.

For example, as shown in Fig. 12, the area of a light-emitting region 010 of one blue sub-pixel is larger than that of a light-emitting region 010 of one red sub-pixel 010, and the area of a light-emitting region 010 of one red sub-pixel is larger than that of a light-emitting region 010 of one green sub-pixel 010.

For example, as shown in Fig. 12, the sub-pixel 10 includes a first pixel group and a second pixel group arranged alternately in the Y direction, the first pixel group and the second pixel group are offset with respect to each other in the X direction, the first pixel group includes red sub-pixels and blue sub-pixels alternately arranged along the X direction, and the second pixel group includes green sub-pixels arranged in the X direction. For example, one red sub-pixel is surrounded by four green sub-pixels, and one blue sub-pixel is surrounded by four green sub-pixels.

In some examples, as shown in Fig. 12, at least one sub-defining structure 330 includes an annular sub-defining structure 330 surrounding a light-emitting region 010 of at least one sub-pixel 10. For example, the light-emitting region 010 of the sub-pixel 10 of the same color is surrounded by a ring-shaped sub-defining structure 330 to improve the uniformity of the height of the pixel-defining portion 230 around the light-emitting region 010.

For example, as shown in Fig. 12, the light-emitting region 010 of the third color sub-pixel 103 is surrounded by the annular sub-defining structure 330, for example, the light-emitting region 010 of the red sub-pixel is surrounded by the annular sub-defining structure 330. Of course, the embodiments of the present disclosure are not limited thereto. For example, the light-emitting region 010 of the green sub-pixel is surrounded by the annular sub-defining structure 330.

For example, as shown in Fig. 12, the orthotropic projection of the annular sub-defining structure 330 on the base substrate 01 overlaps with the orthotropic projection of the first electrode 110 of the third color sub-pixel 103 on the base substrate 01. For example, the annular sub-defining structure 330 is located between the first color sub-pixel 101 and the third color sub-pixel 103, and the orthotropic projection of the annular sub-defining structure 330 on the base substrate 01 overlaps with the orthotropic projection of the first electrode 110 of the first color sub-pixel 101 on the base substrate 01.

For example, as shown in Fig. 12, a strip-shaped sub-defining structure 330 is arranged between the first color sub-pixel 101 and the third color sub-pixel 103. For example, the light-emitting region 010 of the first color sub-pixel 101 is quadrilateral, such as including two long edges parallel to each other and two short edges parallel to each other, and the two long edges and two short edges are connected end to end in turn. For example, the strip-shaped sub-defining structure 330 is located on a side close to a long edge of the light-emitting region 010 of the first color sub-pixel 101. For example, the strip-shaped sub-defining structure 330 is provided parallel to the long edge of the light-emitting region 010 of the first color sub-pixel 101.

For example, as shown in Fig. 12, in the extension direction of the long edge of the light-emitting region 010 of the first color sub-pixel 101, the length of the strip-shaped sub-defining structure 330 is greater than the length of the long side, so that it is possible to better isolate at least one layer of the light-emitting functional layer 130 between the first color sub-pixel 101 and the second color sub-pixel 102.

In some examples, as shown in Fig. 12, at least one second opening 220 is shaped as a strip, and at least one second opening 220 is located between two adjacent sub-pixels 10 of different colors, and the long sides of the strip are perpendicular to the direction of the two adjacent sub-pixels 10 of different colors. For example, each second opening 220 is strip-shaped.

For example, as shown in Fig. 12, the second opening 220 with a strip shape is parallel to the strip-shaped sub-defining structure 330, and the length of the second opening 220 is not greater than the length of the strip-shaped sub-defining structure 330, whereby the length of the second opening 220 determines the size used to block at least one layer of the light-emitting functional layer, thereby determining the degree of crosstalk between two adjacent sub-pixels 10 of different colors.

For example, as shown in Fig. 12, the lengths of the second openings 220 on both sides of the long edges of the light-emitting region 010 of the first color sub-pixel 101 are the same as the lengths of the strip-shaped sub-emitting structures 330 exposed by the second openings. At this time, it is necessary to control the uniformity of the second opening and the defining structure at different positions in the pixel-defining pattern to ensure the uniformity of the isolation effect of at least one layer of the light-emitting functional layer.

In some examples, as shown in Fig. 12, the long edge of the strip-shaped second opening 220 is parallel to the edge of the first opening 210 closest to it. For example, the first opening 210 closest to the long edge of the strip-shaped second opening 220 is the first opening 210 exposing the first electrode 110 of the first color sub-pixel 101 or the first electrode 110 of the second color sub-pixel 102, and the long edge of the strip-shaped second opening 220 is parallel to the edge of the first opening 210. For example, the edges of the light-emitting region 010 of the first color sub-pixel 101 and the adjacent second color sub-pixel 102 are set parallel to each other, and the long edge of the second opening 220 between the adjacent first color sub-pixel 101 and the second color sub-pixel 102 is parallel to the edge of the light-emitting region 010 of the sub-pixels of two colors.

For example, as shown in Fig. 12, the orthogonal projection of the strip-shaped sub-defining structure 330 located between the first color sub-pixel 101 and the second color sub-pixel 102 on the base substrate 01 overlaps with the orthogonal projection of the first electrode 110 of at least one of the first color sub-pixel 101 and the second color sub-pixel 102 on the base substrate 01.

For example, as shown in Fig. 12, the number of second openings 220 for exposing the annular sub-defining structure 330 surrounding the same third color sub-pixel 103 is four, each second opening 220 is in a strip shape, and the long edges of the four second openings 220 are parallel to the four edges of the quadrilateral light-emitting region 010 of the third color sub-pixel 103, respectively.

For example, as shown in Fig. 12, the long edges of the four second openings 220 surrounding the third color sub-pixel 103 all have a length larger than that of the edges of the light-emitting region 010 of the third color sub-pixel 103. For example, the four second openings 220 surrounding the third color sub-pixel 103 are located between the third color sub-pixel 103 and the first color sub-pixel 101.

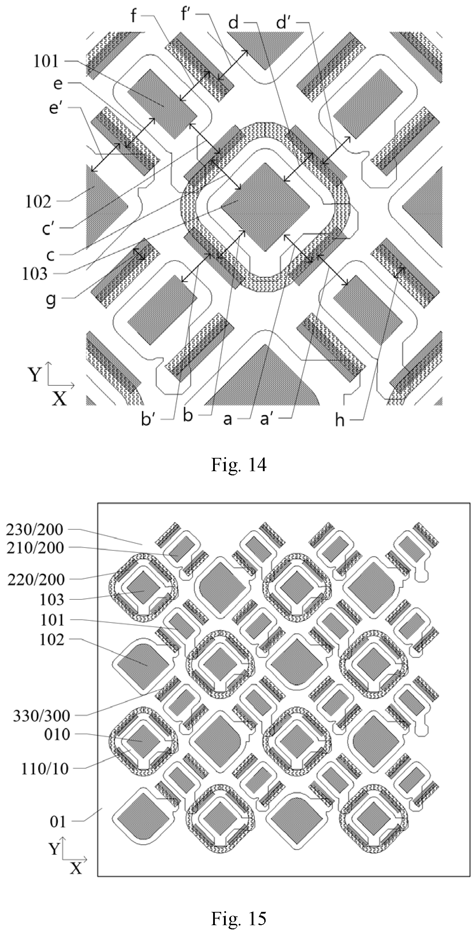

Fig. 14 is a partial enlarged view of the display substrate shown in Fig. 12.

For example, as shown in Fig. 12 and Fig. 14, the distance between the four edges of the light-emitting region 010 of the third color sub-pixel 103 and the edges exposed by the annular sub-defining structure 330 by the second opening 220 are *a, b, c,* and *d,* respectively. For example, the values of *a, b, c,* and *d* are in the following ranges: s0≤*a*≤20 µm, 0≤*b*≤20 µm, 0≤*c*≤20 µm, 0≤*d*≤20 µm. For example, all of *a, b, c,* and *d* can be equal to each other, or at least one of them can be unequal to the other three. For example, the distance between the annular sub-defining structure 330 and the light-emitting regions 010 of the four first-color sub-pixels 101 surrounding it are a', b', c', d', respectively. For example, the values of a', b', c', d' are in the following ranges: 0≤a'≤20 µm, 0≤b'≤20 µm, 0≤c'≤20 µm, 0≤d'≤20 µm. For example, all of a', b', c', d' can be equal, or at least one can be unequal to the other three, such as a'=c'≠b'=d', or a' ≠b' ≠c' ≠d'. For example, the first color sub-pixel 101 is only provided with a long strip-shaped sub-defining structure 330 close to the long edge of its light-emitting region 010, and the distance between the long edges of the light-emitting region 010 of the first-color sub-pixel 101 and two strip-shaped sub-defining structures 330 adjacent to the long edges are *e* and *f*, respectively. For example, the values of *e* and *f* are in the following ranges: 0≤*e*≤20 µm, 0≤*f*≤20 µm. For example, *e* and *f* can be equal or unequal. For example, the second opening 220 can be a slot between the sub-pixels 10 in the pixel-defining pattern 200, the width of the second opening 220 needs to be considered for the width of the defining structure 300, and the width of the second opening 220 needs to consider the distance between the light-emitting regions 010 of the adjacent sub-pixels 10, the width of the second opening 220 is *g,* and the value range of *g* includes: 0≤*g*≤20 µm. For example, the width of the second opening 220 at different locations can be equal. For example, the width of the sub-defining structure 330 can be *h,* and the value range of *h* includes 0≤*h*≤5 µm. For example, the overlapping width of the second opening 220 and the sub-defining structure 330 needs to consider the isolating effect of the material of the light-emitting functional layer 130, such as the overlapping width is between 0 to *h.*

In some examples, as shown in Fig. 12, at least one sub-defining structure 330 includes one sub-defining structure 330, and the edge of the first portion 310 of the sub-defining structure 330 is closer to the edge of the light-emitting region 010 of the first color sub-pixel 101. For example, one sub-defining structure 330 is provided between the first color sub-pixel 101 and the second color sub-pixel 102, and the distance between the sub-defining structure 330 and the light-emitting region 010 of the first color sub-pixel 101 is smaller than the distance between the sub-defining structure 330 and the light-emitting region 010 of the second color sub-pixel 102.

For example, as shown in Fig. 12, one sub-defining structure 330 is provided between the first-color sub-pixel 101 and the third-color sub-pixel 103, and the sub-defining structure 330 is closer to the third-color sub-pixel 103.

For example, as shown in Fig. 12, only the edge of the second portion 320 of the defining structure 300 plays the role of isolating the light-emitting functional layer 130. Setting the edge closer to the red sub-pixel may maximize the isolating effect of the red sub-pixel, but not limited thereto, the edge can also be set closer to the green sub-pixel. For example, Fig. 12 schematically shows that part of the edge of the defining structure 300 that functions to isolate the light-emitting functional layer 130 located between the blue sub-pixel and the green sub-pixel is closer to the green sub-pixel, but is not limited to, and the edge can also be closer to the blue sub-pixel. For example, the annular sub-defining structure 330 surrounding the red sub-pixel can also be sub-defining structures 330 having a strip shape located on both sides of the green sub-pixel. For example, the strip-shaped sub-defining structures 330 located on both sides of the green sub-pixel can also be sub-defining structure 330 having an annular shape. For example, the second opening 220 cannot be set up as a closed ring structure around any light-emitting region 010. For example, the number of the second openings 220 surrounding any light-emitting area 010 can be multiple and are arranged at intervals, and the size of the second opening 220 is related to the process.

In some examples, as shown in Fig. 12, there are two closest sub-defining structures 330 are arranged on both sides of the same sub-pixel 10, and one of the two sub-defining structures 330 is a structure that is rotationally symmetric with respect to the center of the light-emitting region 010 of the same sub-pixel 10 of the other one of the two sub-defining structures. For example, the two sub-defining structures 330 on both sides of the long edges of the light-emitting region 010 of the first color sub-pixel 101 can be symmetrically distributed relative to the center line of the light-emitting region 010 extending along the direction of its long edges, so as to improve the symmetry of the pixel-defining portion 230. For example, one of the above two sub-defining structures 330 is rotated by 180 degrees around the center of the light-emitting region 010 and then coincides with the other sub-defining structure 330. On the one hand, the symmetrical design can provide symmetrical isolation effect in a specific direction, and on the other hand, when the symmetrical arranged sub-defining structures play the role of supporting the mask, it is conducive to improving the uniformity of the support force of the evaporation mask.

For example, Fig. 13 only shows a defining structure 300 located on one side of the first color sub-pixel 101, for example, both sides of the first color sub-pixel 101 are provided with the defining structure 300. For example, the sub-defining structures 330 located on both sides of the same sub-pixel 10 both have one side edge covered by the pixel-defining portion 230 and the other side edge exposed by the second opening 220. For example, the defining structure 300 located on two sides of the same sub-pixel 10 can be symmetrically distributed relative to the centerline of the light-emitting region 010 of the sub-pixel 10. For example, second openings 220 located on two sides of the same sub-pixel 10 can be symmetrically distributed relative to the center of the light-emitting region 010 of the sub-pixel 10.

For example, as shown in Fig. 12, the edge of the defining structure 300 is closer to the light-emitting region 010 of the first color sub-pixel 101, such as the green sub-pixel, than the edge of the second opening 220. For example, the first portion 310 of the defining structure 300 is closer to the light-emitting region 010 of the first color sub-pixel 101 than the second portion 320 of the defining structure 300. For example, the edge of the defining structure 300 is closer to the light-emitting region 010 of the third color sub-pixel 103, such as the red sub-pixel, than the edge of the second opening 220. For example, the first portion 310 of the defining structure 300 is closer to the light-emitting region 010 of the third color sub-pixel 103 than the second portion 320 of the defining structure 300.

For example, as shown in Fig. 12, the edge of the defining structure 300 is farther away from the light-emitting region 010 of the second color sub-pixel 102, such as the blue sub-pixel, than the edge of the second opening 220. For example, the second portion 320 of the defining structure 300 is closer to the light-emitting region 010 of the second color sub-pixel 102 than the first portion 310 of the defining structure 300.

The data writing voltage of different color sub-pixels is different, resulting in the blue sub-pixel and green sub-pixel being susceptible to low gray scale caused by the current leakage of the red sub-pixel when the low gray scale display screen is displayed, such as the red sub-pixel crosstalk to the blue sub-pixel or the green sub-pixel. Therefore, the display substrate provided in this example can increase the proportion of channels of the second electrode around the light-emitting region of the blue sub-pixel by setting the defining structure farther away from the blue sub-pixels, thereby improving the continuity of the second electrode, preventing the increase of cross-voltage, and improving the display uniformity.

Fig. 15 is a schematic diagram of a partial planar structure of the display substrate provided according to another example of an embodiment of the present disclosure. The display substrate shown in Fig. 15 differs from the display substrate shown in Fig. 12 in that the relative positional relationships among the defining structure 300, the second opening 220, and the light-emitting region 010 of the sub-pixel 10 of different colors are different.

For example, as shown in Fig. 15, the edge of the second opening 220 is closer to the light-emitting region 010 of the first color sub-pixel 101 than the edge of the defining structure 300. For example, the second portion 320 of the defining structure 300 is closer to the light-emitting region 010 of the first color sub-pixel 101 than the first portion 310. For example, the edge of the second opening 220 is closer to the light-emitting region 010 of the third color sub-pixel 103 than the edge of the defining structure 300. For example, the second portion 320 of the defining structure 300 is closer to the light-emitting region 010 of the third color sub-pixel 103 than the first portion 310 of the defining structure 300.

For example, as shown in Fig. 15, the defining structure 300 located between the first color sub-pixel 101 and the third color sub-pixel 103 is closer to the light-emitting region 010 of the third-color sub-pixel 103, so as to maximize the isolating effect of at least one layer of the light-emitting functional layer 130 of the third-color sub-pixel 103, thereby preventing crosstalk.

In addition to the position relationship among the defining structure, the second opening and the light-emitting region shown in Fig. 15, which is different from the position relationship among the defining structure, the second opening and the light-emitting region shown in Fig. 12, other structures in the display substrate shown in Fig. 15 can have the same characteristics as the other structures in the display substrate shown in Fig. 12, which will not be described again here. The shape of the defining structure in the display substrate shown in Fig. 15 can be the same as the shape of the defining structure in the display substrate shown in Fig. 12, the shape of the second opening shown in Fig. 15 can be the same as the shape of the second opening shown in Fig. 12, and the shape and distribution of each light-emitting region shown in Fig. 15 can be the same as the shape and distribution of each light-emitting region in the substrate shown in Fig. 12.

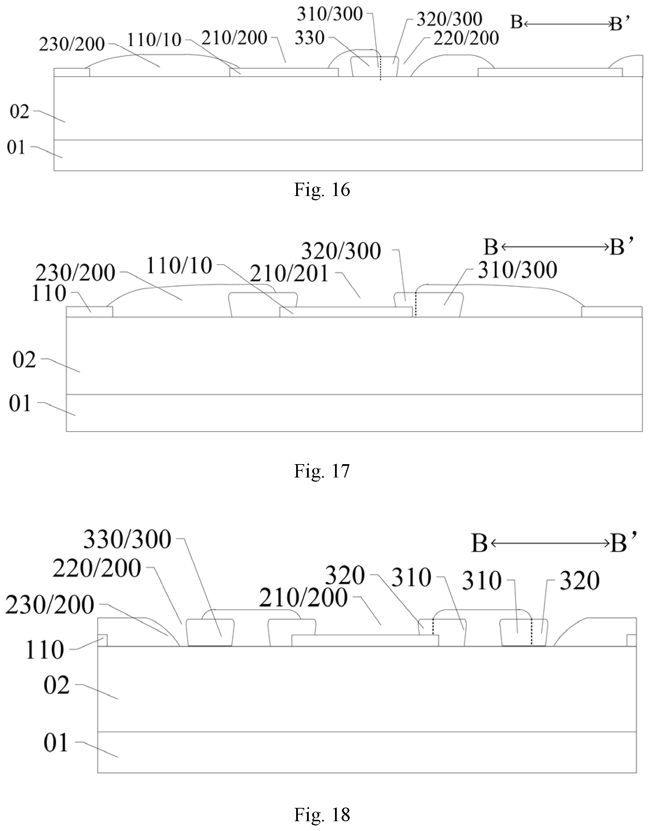

Fig. 16 is a schematic diagram of a partial cross-sectional structure of a display substrate provided according to another example of an embodiment of the present disclosure. Fig. 16 may be a schematic diagram of a partial cross-sectional structure taken along the line BB' in the display substrate.

The display substrate shown in Fig. 16 differs from the display substrate shown in Fig. 12 to Fig. 14 in that the defining structure 300 is provided on only one side of the sub-pixel 10 of the same color.

For example, as shown in Fig. 16, the defining structure 300 is located only on one side of the first opening 210 of the pixel-defining pattern 200, and only the position of the defining structure 300 is provided with the second opening 220. For example, the defining structure 300 can be located on one side of a particular color sub-pixel 10, such as a red sub-pixel, a green sub-pixel, or a blue sub-pixel. For example, the defining structure 300 can be located between two specific color sub-pixels 10, such as between a green sub-pixel and a blue sub-pixel, or between a green sub-pixel and a red sub-pixel. For example, the defining structure 300 can correspond to three color sub-pixel 10. For example, the defining structure 300 may include a plurality of sub-defining structures 330, and the plurality of sub-defining structures 330 may be provided uniformly or at a specific location in the display region. The embodiments of the present disclosure do not limit the position of the defining structure, which can be set according to the needs of the product.

In the example shown in Fig. 16, except that the position of the defining structure 300 in the display substrate is different from the position of the defining structure 300 in the display substrate shown in Fig. 12 to Fig. 14, the other structures in the display substrate shown in Fig. 16 can have the same characteristics as the corresponding structures in the display substrate shown in Fig. 12 to Fig. 14, which will not be described again here. For example, the cross-section of the defining structure 300 shown in the display substrate shown in Fig. 16 can have the same characteristics as the cross-section of the defining structure 300 shown in the display substrate shown in Fig. 12 to Fig. 14, and will not be described again here.

Fig. 17 and Fig. 18 are schematic diagrams of partial cross-sectional structures of a display substrate provided according to different examples of an embodiment of the present disclosure. Fig. 17 and Fig. 18 may be a schematic diagram of a partial cross-sectional structure taken along the line BB' in the display substrate.

The display substrate shown in Fig. 17 differs from the display substrate shown in Fig. 12 to Fig. 14 in that the relative positional relationship between the defining structure 300 and the pixel-defining pattern 200 is different, and the relative positional relationship between the defining structure 300 and the first electrode 110 is different.

In some examples, as shown in Fig. 17, the defining structure 300 covers the edge of the first electrode 110. By covering the edge of the first electrode 110 with the defining structure 300, it is beneficial to prevent the edge of the pixel-defining portion 230 from being too thin to cover the first electrode 110, resulting in the exposure of the edge of the first electrode 110 and causing poor display performance.

In some examples, as shown in Fig. 17, the size of a part, of the defining structure 300, covering the first electrode 110 is not greater than 5 microns in the direction of arrangement of two adjacent sub-pixels 10 of different colors. For example, the size of the part, of the defining structure 300, covering the first electrode 110 is not greater than 5 microns in the direction of the line BB' shown in the figure. For example, in the extension direction of the line BB', the size of the part, of the defining structure 300, covering the first electrode 110 is greater than 0. For example, in the direction of the line BB' shown in the figure, the size of the part, of the defining structure 300, covering the first electrode 110 may be 1 micron, or 2 microns, or 3 microns. The size of the part, of the defining structure 300, covering the first electrode 110 may be any value greater than 0 microns and less than 5 microns, which will not be enumerated again herein.

For example, as shown in Fig. 17, the size of the part, of the defining structure 300, covering the first electrode 110 may be a size perpendicular to the extension direction of the defining structure 300.

In some examples, as shown in Fig. 17, the second portion 320 of the defining structure 300 is at least exposed by the first opening 210. For example, the area of the orthogonal projection of the second portion 320 of the defining structure 300 on the base substrate 01 is smaller than the area of the orthogonal projection of the first portion 310 of the defining structure 300 on the base substrate 01. For example, the defining structure 300 covers only a portion of the edges of the same first electrode 110 so that at least part, in the first opening 210, of the film layer is a continuous structure. The part of the defining structure 300 exposed by the first opening 210 and the first opening 210 together define the light-emitting region 010 of the sub-pixel 10.

For example, as shown in Fig. 17, all the openings 201 included in the pixel-defining pattern 200 in the display substrate are the first openings 210, the light-emitting functional layer 130 is continuously arranged at part of the first opening 210, and at least one layer of the light-emitting functional layer 130 at part of the first opening 210 is disconnected. For example, as shown in Fig. 17, the display substrate may not include the second opening 220 in the example shown in Fig. 12.

Fig. 17 schematically shows that edges of both sides of the first electrode 110 on the extension direction of the line BB' are covered by the defining structure 300. However, it is not limited thereto, and the first electrode 110 can also be configured so that one side edge of the first electrode 110 is covered by the defining structure 300, and the other edge of the first electrode 110 is covered by the pixel-defining portion 230.

For example, as shown in Fig. 17, in the direction perpendicular to the base substrate 01, the first portion 310 of the defining structure 300 does not overlap with the first electrode 110, and the second portion 320 of the defining structure 300 overlaps with the first electrode 110.

For example, as shown in Fig. 17, the edge of the first electrode 110 of one color sub-pixel 10 can be covered by the defining structure 300, and the edge of the first electrode 110 of another color sub-pixel 10 can be covered by the pixel-defining portion 230. For example, in two adjacent sub-pixels 10 of different colors, only the first electrode 110 of one sub-pixel 10 is covered by the defining structure 300, and the first electrode 110 of the other sub-pixel 10 is covered by the pixel-defining portion 230.

Of course, the embodiments of the present disclosure are not limited thereto. The defining structure 300 shown in Fig. 12 to Fig. 15 can also be combined into the defining structure 300 shown in Fig. 17. For example, the edge of the first electrode 110 at part of the positions is covered by the defining structure 300, and the first electrode 110 at the part of the positions is spaced apart from the defining structure 300.

In the example shown in Fig. 17, except that the position of the defining structure 300 and the pixel-defining pattern in the display substrate are different from the position of the defining structure 300 and the pixel-defining pattern 200 in the display substrate shown in Fig. 12 to Fig. 14, the other structures in the display substrate shown in Fig. 17 can have the same characteristics as the corresponding structures in the display substrate shown in Fig. 12 to Fig. 14, which will not be described again here. For example, the cross-section of the defining structure 300 shown in the display substrate shown in Fig. 17 can have the same characteristics as the cross-section of the defining structure 300 shown in the display substrate shown in Fig. 12 to Fig. 14, and will not be described again here.

Fig. 18 shows that two sub-defining structures 330 may be provided between two adjacent sub-pixels in the display substrate, one of the two sub-defining structures 330 covers the edge of the first electrode 110 and is exposed by the first opening 210, similar to the sub-defining structure 330 covering the edge of the first electrode 110 and being exposed by the first opening 210 as shown in Fig. 17.

In some examples, as shown in Fig. 18, at least one sub-defining structure 330 located between two adjacent sub-pixels includes two sub-defining structures 330 that are spaced apart from each other, the second portion 320 of one of the two sub-defining structures 330 is exposed by the first opening 210, and the second portion 320 of the other of the two sub-defining structures 330 is exposed by the second opening 220. By providing two sub-defining structures 330 between two adjacent sub-pixels, one of the two sub-defining structures 330 is exposed by the first opening 210 while covering the edge of the first electrode 110, and the other of the two sub-defining structures 330 is exposed by the second opening 220. This not only may further improve the disconnecting effect of the light-emitting functional layer 130, further reducing crosstalk, it is also possible to reduce the risk that the edge of the first electrode 110 is exposed to cause corrosion. Of course, the embodiment of the present disclosure is not limited thereto. For example, one of the two sub-defining structures 330 may only cover the edge of the first electrode 110 without being exposed by the first opening 210, and the other of the two sub-defining structures 330 is exposed by the second opening 220.

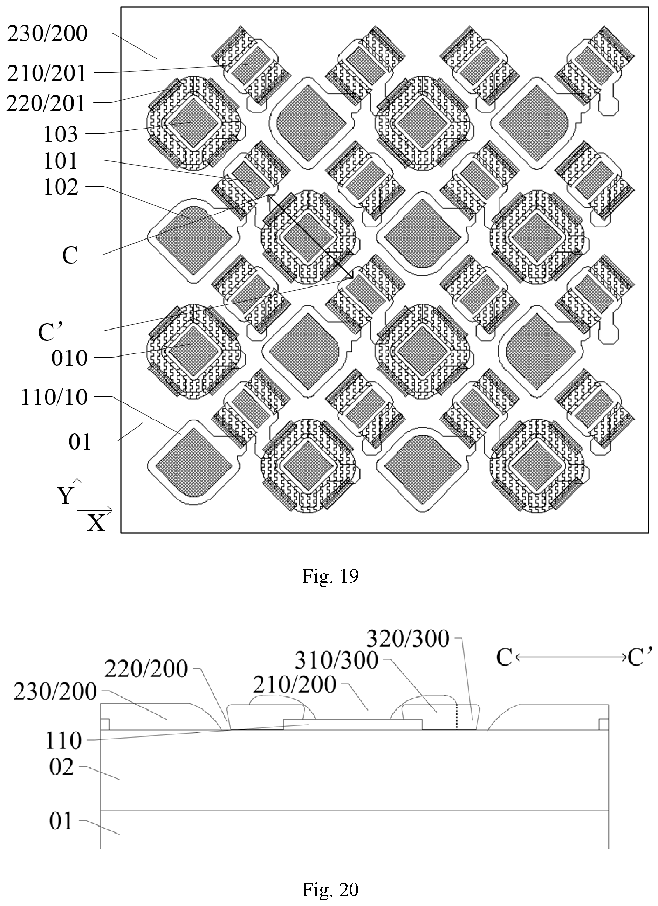

Fig. 19 is a schematic diagram of a partial planar structure of the display substrate provided according to another example of an embodiment of the present disclosure. Fig. 20 is a schematic diagram of a partial cross-sectional structure taken along the CC' line shown in Fig. 19. The display substrate shown in Fig. 19 differs from the display substrate shown in Fig. 12 in that the width of the defining structure 300 and the position relationship between the defining structure 300 and the first electrode 110. The display substrate shown in Fig. 20 differs from the display substrate shown in Fig. 17 in that the openings 201 exposing the defining structure 300 are different.

For example, as shown in Fig. 19 and Fig. 20, the defining structure 300 covers the edge of the first electrode 110, and the part of the defining structure 300 covering the edge of the first electrode 110 is the first portion 310 of the defining structure 300. For example, the first electrode 110 includes a portion exposed by the first opening 210, a portion covered by the pixel-defining portion 230, and a portion covered by the defining structure 300. By covering the edge of the first electrode 110 with the defining structure 300, it is beneficial to prevent the edge of the pixel-defining portion 230 from being too thin to cover the first electrode 110, resulting in the exposure of the edge of the first electrode 110 and causing poor display performance.

For example, as shown in Fig. 19 and Fig. 20, the second portion 320 of the defining structure 300 is only exposed by the second opening 220 and not exposed by the first opening 210.

In the example shown in Fig. 19 and Fig. 20, except that the position of the defining structure 300 in the display substrate is different from the position relationship between the defining structure 300 and the first electrode 110 in the display substrate shown in Fig. 12 to Fig. 14, the other structures in the display substrate shown in Fig. 19 and Fig. 20 can have the same characteristics as the corresponding structures in the display substrate shown in Fig. 12 to Fig. 14, which will not be described again here. For example, the cross-section of the defining structure 300 shown in the display substrate shown in Fig. 19 and Fig. 20 can have the same characteristics as the cross-section of the defining structure 300 shown in the display substrate shown in Fig. 12 to Fig. 14, and will not be described again here.

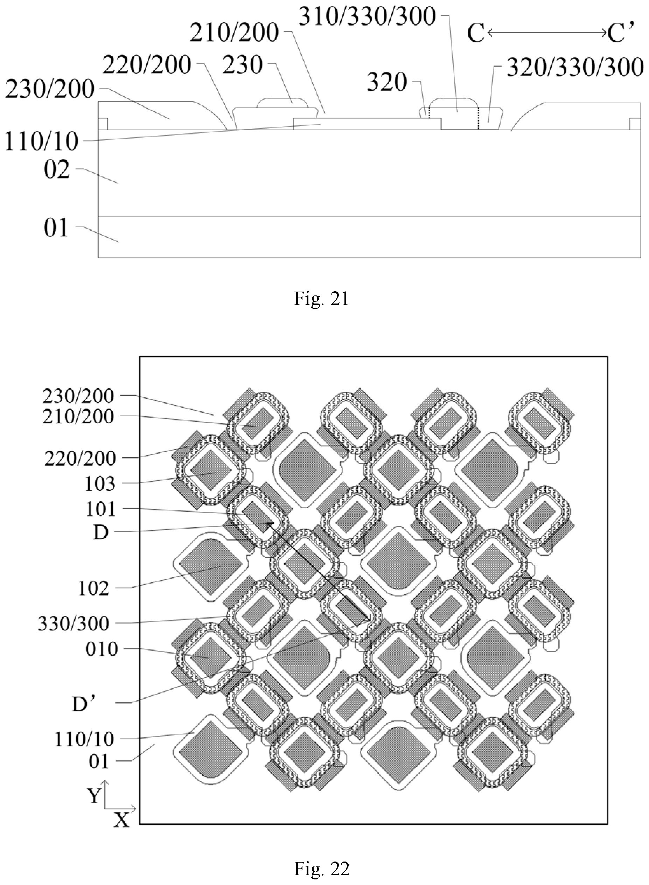

Fig. 21 is a schematic diagram of a partial cross-sectional structure of a display substrate provided according to another example of an embodiment of the present disclosure. The display substrate shown in Fig. 21 differs from the display substrate shown in Fig. 20 in the position relationship between the defining structure 300 and the first opening 210.

In some examples, as shown in Fig. 21, at least one sub-defining structure 330 located between two adjacent sub-pixels 10 includes one sub-defining structure 330, the side edge of the sub-defining structure 330 is exposed by the first opening 210, and the other side edge of the sub-defining structure 330 is exposed by the second opening 220. Exposing the edges of the two sides of the sub-defining structure 330 by the first opening 210 and the second opening 220 respectively and covering the edge of the first electrode 110 by the sub-defining structure 330 not only further improve the isolation effect of the light-emitting functional layer 130, further reducing crosstalk, but also reduce the risk of corrosion occurred at the exposed edge of the first electrode 110.

For example, as shown in Fig. 21, the sub-defining structure 330 includes two second portion 320 and the first portion 310 located between the two second portion 320, and the two second portion 320 are exposed by the first opening 210 and the second opening 220, respectively. For example, the area of the orthogonal projection of the second portion 320 exposed by the first opening 210 on the base substrate 01 is not greater than the area of the orthotropic projection of the second portion 320 exposed by the second opening 220 on the base substrate 01.

In the example shown in Fig. 21, except that the position relationship of the defining structure 300, the pixel-defining pattern 200, and the first electrode 110 in the display substrate is different from the position relationship between the defining structure 300, the pixel-defining pattern 200, and the first electrode 110 in the display substrate shown in Fig. 12 to Fig. 14, the other structures in the display substrate shown in Fig. 21 can have the same characteristics as the corresponding structures in the display substrate shown in Fig. 12 to Fig. 14, which will not be described again here. For example, the cross-section of the defining structure 300 shown in the display substrate shown in Fig. 21 can have the same characteristics as the cross-section of the defining structure 300 shown in the display substrate shown in Fig. 12 to Fig. 14, and will not be described again here.

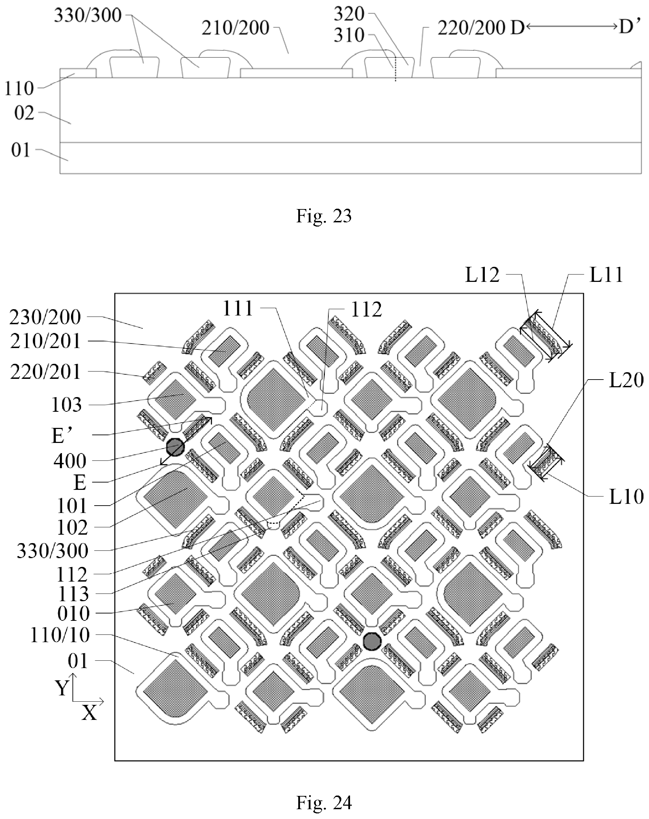

Fig. 22 is a schematic diagram of a partial planar structure of the display substrate provided according to another example of an embodiment of the present disclosure. Fig. 23 is a schematic diagram of a partial cross-sectional structure taken along the DD' line shown in Fig. 22. The display substrate shown in Fig. 22 differs from the display substrate shown in Fig. 12 in that the shape of the defining structure 300 surrounding the first color sub-pixel 101 is different, and the position relationship between the defining structure 300 surrounding the first color sub-pixel 101 and the second opening 220 is different.

For example, as shown in Fig. 22 and Fig. 23, one sub-defining 330 is arranged between the first color sub-pixel 101 and the second color sub-pixel 102 that are provided adjacent to each other, and two sub-defining structures 330 are arranged between the first color sub-pixel 101 and the third color sub-pixel 103 that are provided adjacent to each other. Varying the number of sub-defining structures 330 provided between different color sub-pixels may reduce the crosstalk between the first color sub-pixel 101 and the third color sub-pixel 103 that are prone to crosstalk, while increasing the size of the channel of the second electrode 120 around the second color sub-pixel 102, thereby increasing the continuity of the second electrode 120. Of course, the embodiment of the present disclosure is not limited thereto. The two sub-defining structures 330 may also be arranged between the first color sub-pixel 101 and the second color sub-pixel 102.

In some examples, as shown in Fig. 22 and Fig. 23, at least one sub-defining structure 330 located between two adjacent sub-pixels includes two sub-defining structures 330 that are spaced apart, and the edges of the two sub-defining structures 330 opposite each other are exposed by the same second opening 220, further improving the isolating effect of the light-emitting functional layer 130 of the adjacent two sub-pixels 10. For example, two second portions 320 in the two sub-defining structures 330 are in close proximity to each other.

In some examples, as shown in Fig. 22 and Fig. 23, the two sub-defining structures 330 are two annular sub-defining structures 330 surrounding light-emitting regions 010 of two different color sub-pixels 10. For example, the light-emitting region 010 of the first color sub-pixel 101 and the light-emitting region 010 of the third color sub-pixel 103 are respectively surrounded by the two annular sub-defining structures 330, and the edges of the two annular sub-defining structures 330 close to each other are exposed by the same second opening 220. For example, a plurality of second openings 220 expose each annular sub-defining structure 330, and the plurality of second openings 220 are spaced apart from each other.

By setting the light-emitting regions of the two adjacent sub-pixels to be surrounded by the annular sub-defining structure, the height uniformity of the pixel-defining portion around the light-emitting regions of the two adjacent sub-pixels is improved.

Fig. 22 schematically shows that the light-emitting region 010 of the first color sub-pixel 101 and the light-emitting region 010 of the third-color sub-pixel 103 are both surrounded by annular sub-defining structures 330. However, it is not limited thereto. For example, the light-emitting region 010 of the first color sub-pixel 101 and the light-emitting region 010 of the second color sub-pixel 102 are both surrounded by the annular sub-defining structures 330. For example, the light-emitting region 010 of the second color sub-pixel 102 and the light-emitting region 010 of the third color sub-pixel 103 are both surrounded by the annular sub-defining structures 330. For example, the light-emitting region 010 of the first color sub-pixel 101, the light-emitting region 010 of the second color sub-pixel 102, and the light-emitting region 010 of the third color sub-pixel 103 are all surrounded by the annular sub-defining structures 330.

The display substrate in the example shown in Fig. 22 and Fig. 23 is different from the display substrate shown in Fig. 12 to Fig. 14 except that the shape of the defining structure 300 surrounding the first color sub-pixel 101, the position relationship between the defining structure 300 and the second opening 220 around the first color sub-pixel 101, the other structures in the display substrate shown in Fig. 22 and Fig. 23 can have the same characteristics as the corresponding structures in the display substrate shown in Fig. 12 to Fig. 14, and will not be described again here. For example, the cross-section of the defining structure 300 in the display substrate shown in Fig. 21 can have the same characteristics as the cross-section of the defining structure 300 in the display substrate shown in Fig. 12 to Fig. 14, and will not be described again here.

It should be noted that the display substrate in the examples shown in Fig. 12 to Fig. 22 schematically shows that the defining structure and the second opening overlap with the first electrode of the sub-pixel, but the schematic diagram does not limit the overlapping relationship of the defining structure and the second opening and the first electrode. For example, as shown in the examples shown in Fig. 12 to Fig. 22, at least one of the defining structure and the second opening in the display substrate may not overlap with any first electrode.

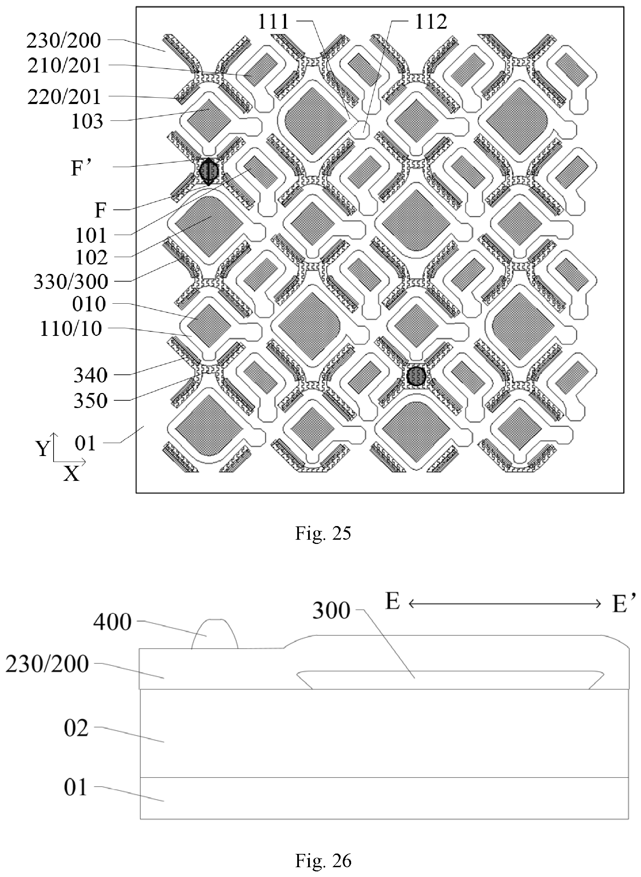

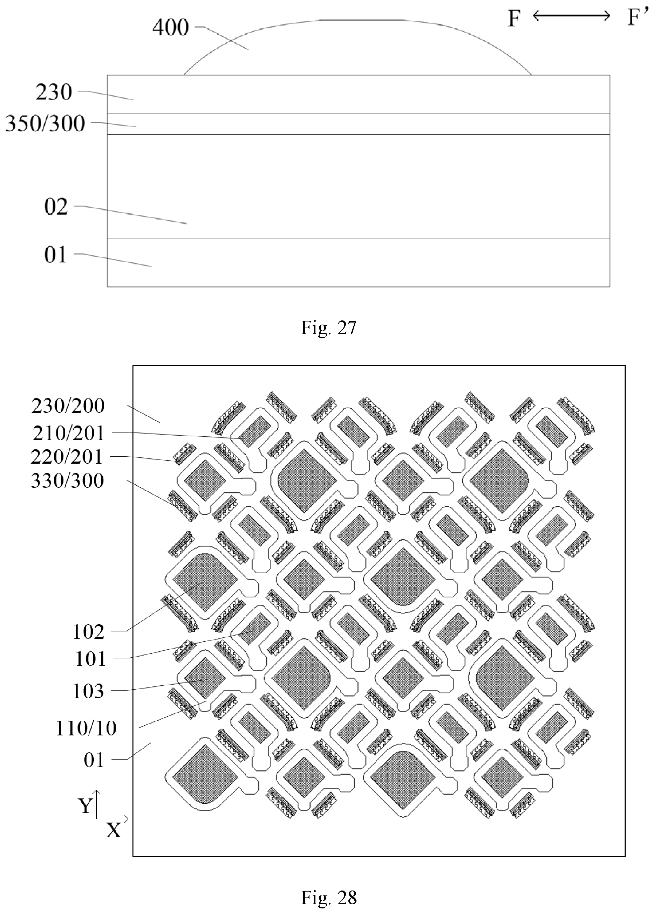

Fig. 24 and Fig. 25 are schematic diagrams of partial planar structures of a display substrate provided according to different examples of an embodiment of the present disclosure; Fig. 26 is a schematic diagram of a partial cross-sectional structure taken along the EE' line shown in Fig. 24. Fig. 27 is a schematic diagram of a partial cross-sectional structure taken along the FF' line shown in Fig. 25.

The display substrates shown in Fig. 24 and Fig. 25 differ from those shown in Fig. 12 to Fig. 14 in that the shape and position of the defining structure 300 and the second opening 220 are different. Fig. 24 and Fig. 25 also show a photo spacer 400.

In some examples, as shown in Fig. 24 to Fig. 27, the display substrate further includes the photo spacer 400 located on a side of the pixel-defining portion 230 away from the base substrate 01, and the material of the defining structure 300 is different from that of the photo spacer 400. For example, the photo spacer 400 (PS) is configured to support a fine metal mask (FMM mask) upon manufacturing the light-emitting layer.

For example, as shown in Fig. 24 to Fig. 27, the material of the defining structure 300 may include a negative photoresist, and the material of the photo spacer 400 may include a positive photoresist. For example, the positive photoresist is a photoresist that degrades the illuminated part and dissolves in the developer, leaving behind a pattern of the non-exposed part that matches the pattern of the mask. The negative photoresist refers to a photoresist that has a cross-chain reaction in the illuminated part and becomes an insoluble substance, and the non-exposed part is dissolved by the developer, and the pattern formed is complementary to the pattern of the mask.

In some examples, as shown in Fig. 24 to Fig. 27, the thickness of the photo spacer 400 is not greater than 5 microns, and the thickness of the pixel-defining portion 230 is not greater than 5 microns. For example, the thickness of the photo spacer 400 is not greater than 4 microns, and the thickness of the pixel-defining portion 230 is not greater than 4 microns. For example, the thickness of the pixel-defining portion 230 is greater than 1 micron. For example, the thickness of the photo spacer 400 is greater than 1 micron. For example, in the direction perpendicular to the base substrate 01, the thickness of the overlap between the pixel-defining portion 230 and the defining structure 300 can be smaller than the thickness of the defining structure 300. For example, in the direction perpendicular to the base substrate 01, the thickness of the overlapping part of the pixel-defining portion 230 and the defining structure 300 can be 1.1 microns to 1.3 microns, and the thickness of the defining structure 300 can be 1.4 microns to 1.6 microns.

For example, as shown in Fig. 24 and Fig. 26, the photo spacer 400 does not overlap with the defining structure 300 in the direction perpendicular to the base substrate 01. For example, the thickness of the photo spacer 400 can be greater than the thickness of the defining structure 300 to support the mask plate by the photo spacer 400.

In some examples, as shown in Fig. 25 and Fig. 27, the orthogonal projection of the photo spacer 400 on the base substrate 01 overlaps with the orthogonal projection of the defining structure 300 on the base substrate 01. For example, the orthogonal projection of the photo spacer 400 on the base substrate 01 completely falls within the orthogonal projection of the defining structure 300 on the base substrate 01. Therefore, the structure including the photo spacer 400 and defining structure 300 is used to support the mask plate, which is conducive to improving the support effect.

In some examples, as shown in Fig. 25 and Fig. 27, the defining structure 300 includes a plurality of defining portions 340 and a connecting portion 350 connecting at least a part of the plurality of defining portions 340, the defining portion 340 overlaps with the second opening 220 in the direction perpendicular to the base substrate 01, and the orthogonal projection of the connecting portion 350 on the base substrate 01 completely falls into the orthogonal projection of the pixel-defining portion 230 on the base substrate 01. The orthogonal projection of the photo spacer 400 on the base substrate 01 completely falls into the orthogonal projection of the connecting portion 350 on the base substrate 01.

For example, as shown in Fig. 25, the defining portion 340 is located between the adjacent first color sub-pixel 101 and the second color sub-pixel 102, or between the adjacent first color sub-pixel 101 and the third color sub-pixel 103, and the second portion 320 of the defining portion 340 is exposed by the second opening 220. For example, the connecting portion 350 may be located between the four defining portions 340 and connect the four defining portions 340. For example, the defining portion 340 and the connecting portion 350 can be integrated structures. By setting the defining structure to include the defining portions and connecting portions that are connected with each other, the density of the defining structure can be increased to increase the uniformity of the line width, and the symmetry of the defining structure can further be improved.

For example, as shown in Fig. 25 and Fig. 27, the sum of the heights of the defining structure 300, the pixel-defining portion 230, and the photo spacer 400 that are stacked is not greater than 10 microns. For example, the sum of the heights of the defining structure 300, the pixel-defining portion 230, and the photo spacer 400 that are stacked is not greater than 9 microns, or not greater than 7 microns, or not greater than 5 microns.

For example, as shown in Fig. 25, in the direction perpendicular to the base substrate 01, the size of the connecting portion 350 overlapping the photo spacer 400 in the Y direction is larger than that of the connecting portion 350 that does not overlap with the photo spacer 400 in the Y direction.

For example, as shown in Fig. 25, the defining structure 300 including four defining portions 340 and one connecting portion 350 can be a special-shaped defining structure 300, the defining structure 300 surrounding the first color sub-pixel 101 may include two special-shaped defining structures 300 spaced apart with each other, and the defining structure 300 surrounding the third color sub-pixel 103 may include two special-shaped defining structures 300 spaced apart with each other. For example, the special-shaped defining structure 300 is bent towards the light-emitting region 010 of the first color sub-pixel 101. For example, the special-shaped defining structure 300 is bent towards the light-emitting region 010 of the third color sub-pixel 103.

In some examples, as shown in Fig. 24 and Fig. 25, the first electrode 110 of each sub-pixel includes a main electrode 111 and a connecting electrode 112, and the shape of the main electrode 111 is similar to that of the light-emitting region 010 of the sub-pixel 10. The orthogonal projection of the connecting electrode 112 on the base substrate 01 of at least one sub-pixel does not overlap with the orthogonal projection of the defining structure 300 and the opening 201 on the base substrate 01.

For example, as shown in Fig. 24 and Fig. 25, in the direction perpendicular to the base substrate 01, the main electrode 111 overlaps with the first opening 210 of the pixel-defining pattern 200, and the connecting electrode 112 does not overlap with the first opening 210 of the pixel-defining pattern 200. For example, the connecting electrode 112 is configured to electrically connect with the light-emitting control transistor in the pixel circuit. For example, the first electrode 110 of the third color sub-pixel 103 further includes a shading portion 113 in addition to the main electrode 111 and the connecting electrode 112 to shade some structures in the pixel circuit.

For example, as shown in Fig. 24 and Fig. 25, the orthogonal projection of the connecting electrode 112 of at least part of the sub-pixels 10 on the base substrate 01 does not overlap with the orthogonal projections of the defining structure 300 and the opening 201 on the base substrate 01. For example, the orthogonal projection of the connecting electrode 112 of each sub-pixel 10 on the base substrate 01 does not overlap with the orthogonal projections of the defining structure 300 and the opening 201 on the base substrate 01. For example, the orthotropic projection of the connecting electrode 112 of at least one sub-pixel 10 on the base substrate 01 overlaps with the orthotropic projection of at least one of the defining structure 300 and the opening 201 on the base substrate 01. For example, the orthogonal projection of the connecting electrode 112 of at least one sub-pixel 10 on the base substrate 01 overlaps with at least one of the orthogonal projections of the defining structure 300 and the opening 201 on the base substrate 01, and the overlapping size does not exceed 1 micron.

For example, as shown in Fig. 24 and Fig. 25, the connecting electrode 112 is configured to be electrically connected to the light-emitting control transistor through a via located in the insulating layer between the connecting electrode and the light-emitting control transistor, and the defining structure 300 and the opening 201 do not overlap with the via in at least one sub-pixel 10 in the direction perpendicular to the base substrate. For example, in the direction perpendicular to the base substrate, the defining structure 300 and the opening 201 do not overlap with the via in each sub-pixel 10.

In the display substrate in the example shown in Fig. 24 and Fig. 25, except that the shape and position of the defining structure 300 and the second opening 220 are different from the shape and position of the defining structure 300 and the second opening 220 of the display substrate shown in Fig. 12 to Fig. 14, the other structures in the display substrate shown in Fig. 24 and Fig. 25 can have the same characteristics as the corresponding structures in the display substrate shown in Fig. 12 to Fig. 14, which will not be described again here. For example, the cross-section of the defining structure 300 shown in the display substrate shown in Fig. 21 can have the same characteristics as the cross-section of the defining structure 300 shown in the display substrate shown in Fig. 12 to Fig. 14, and will not be described again here.

For example, Fig. 24 and Fig. 25 schematically show that one sub-defining structure 330 is arranged between two adjacent sub-pixels 10, but is not limited thereto, and two sub-defining structures 330 may be arranged between the two adjacent sub-pixels 10. For example, Fig. 24 and Fig. 25 schematically show the spaced arrangement of the defining structure 300 with the first electrode 110, but is not limited thereto, and the defining structure 300 may also cover the edge of the first electrode 110. For example, Fig. 24 and Fig. 25 schematically show that the defining structure 300 is exposed by the second opening 220, but is not limited thereto, and the defining structure 300 can also be exposed by the first opening 210.

For example, as shown in Fig. 24, the length of at least one sub-defining structure 330 is L11, and the length of the second opening 220 overlapping with the sub-defining structure 330 is L12, and L11 is greater than L12, whereby the size of the second opening limits the degree to which the light-emitting functional layer of the sub-pixel is isolated. For example, the length of at least one sub-defining structure 330 is L10, and the length of the second opening 220 overlapping with the sub-defining structure 330 is L20, and L10 is basically equal to L20. Therefore, it is necessary to control the uniformity of the pixel-defining pattern and the defining structure at different positions in the display substrate to ensure the uniformity of the isolation effect of the light-emitting functional layer. The length of the sub-defining structure 330 may be the maximum size of the sub-defining structure 330 in the extension direction, and the length of the second opening 220 may be the maximum size of the second opening 220 in the extension direction of the sub-defining structure 330.

It should be noted that the cross-sectional drawings shown in Fig. 12 to Fig. 27 are only schematic. For example, the surface of the pixel-defining portion away from the base substrate can have a flat surface at some positions, and can be an arc-shaped surface at some positions, and the features such as the width, height and corners of the defining structure in each cross-sectional drawing, and features such as the width, height and corners of the pixel-defining portion are only schematic, and do not represent the specific size relationship and specific topography characteristics.

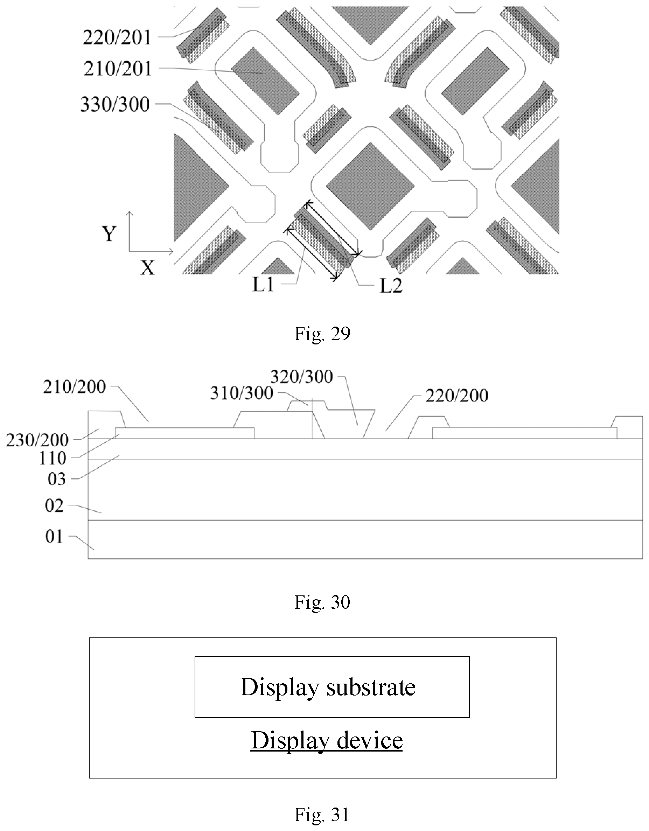

Fig. 28 is a schematic diagram of a partial planar structure of the display substrate provided according to another example of an embodiment of the present disclosure. Fig. 29 is a partial enlarged view of the display substrate shown in Fig. 28. The display substrate shown in Fig. 28 and Fig. 29 differs from the display substrate shown in Fig. 24 in the length relationship between the defining structure 300 and the second opening 220 overlapping with it. In the display substrate shown in Fig. 28 and Fig. 29, except the length relationship between the defining structure and the second opening overlapping with it, the other structures can have the same characteristics as the corresponding structure in the display substrate shown in Fig. 24, and will not be described again here.

For example, as shown in Fig. 28 and Fig. 29, in the extension direction of the sub-defining structure 300, the length of at least one sub-defining structure 330 is L1, and the length of the second opening 220 overlapping the sub-defining structure 330 is L2, and L1 is smaller than L2, so that one side edge of the sub-defining structure is completely exposed, and the length of the sub-defining structure determines the degree to which the light-emitting functional layer is isolated.

Fig. 30 is a schematic diagram of a partial cross-sectional structure of a display substrate provided according to another embodiment of the present disclosure.

As shown in Fig. 13 and Fig. 30, the display substrate includes a base substrate 01, a plurality of sub-pixels 10 and a pixel-defining pattern 200 located on the base substrate 01. Each sub-pixel 10 in at least part of the sub-pixels 10 includes a light-emitting functional layer 130, and the light-emitting functional layer 130 includes a plurality of film layers. The sub-pixel 10 further includes a first electrode 110 and a second electrode 120 located on both sides of the light-emitting functional layer 130 in a direction perpendicular to the base substrate 01 (for example, in a direction perpendicular to the direction of the XY plane as shown in Fig. 12), and the first electrode 110 is located between the light-emitting functional layer 130 and the base substrate 01. The light-emitting functional layer 130 may include a light-emitting layer for emitting light as well as a charge-generating layer 133. The pixel-defining pattern 200 includes a plurality of openings 210 and a plurality of second openings 220, the plurality of first openings 210 are configured to define light-emitting regions 010 of at least part of the sub-pixels 10, and at least part of at least one layer of the light-emitting functional layer 130 in the first opening 210 is a continuous part, and at least a part in at least one of the second openings is partially isolated. As schematically shown in Fig. 12 and Fig. 13, a part of the film layer of the light functional layer 130 in the first opening 210 is a continuous portion, and the part in the second opening 220 is isolated. One sub-pixel 10 corresponds to at least one first opening 210, at least part of the light-emitting functional layer 130 of the sub-pixel 10 is located in the first opening 210 corresponding to the sub-pixel 10, and the first opening 210 is configured to expose the first electrode 110.

As shown in Fig. 30, the display substrate further includes a defining structure 300 located on the base substrate 01, the defining structure 300 is located between at least two adjacent sub-pixels 10 of different colors, the defining structure 300 includes a first portion 310 covering a surface of the pixel-defining portion 230 away from the base substrate 01 and a second portion 320 located in the second opening 220, and the second portion 320 of the defining structure 300 is configured to isolate at least one layer of the light-emitting functional layer. For example, the first portion 310 of the defining structure 300 is located on a side of the pixel-defining portion 230 away from the base substrate 01, and the first portion 312 of the defining structure 300 overlaps the pixel-defining portion 230 in the direction perpendicular to the base substrate 01. For example, at least part of the second portion 320 of the defining structure 300 does not overlap with the pixel-defining portion 230 in the direction perpendicular to the base substrate 01. For example, at least a portion of the second portion 320 of the defining structure 300 covers at least a portion of the side of the pixel-defining portion 230. For example, the second portion 320 of the defining structure 300 does not overlap with a surface of the pixel-defining portion 230 away from the base substrate 01 in the direction perpendicular to the base substrate 01.

As shown in Fig. 30, the material of the defining structure 300 includes an organic material, and an edge of a surface of the second portion 320 of the defining structure 300 away from the base substrate 01 protrudes relative to an edge of a surface of the second portion 320 close to the base substrate 01. For example, an angle between a side of the second portion 320 of the defining structure 300 and a plane where a surface of the defining structure 300 close to the base substrate 01 is located is greater than 20 degrees and less than 90 degrees.

The first portion of the defining structure made of the organic material provided in the present disclosure covers the pixel-defining portion, and while the second portion falls into the second opening, the surface edge of the second portion of the defining structure away from the base substrate is set to protrude relative to the surface edge of the second portion close to the base substrate, which not only can isolate at least one layer of the light-emitting functional layer between the sub-pixels of different colors to reduce crosstalk, but also ensure the electrode flatness of the sub-pixels and the normal light emitting effect, while minimizing the impact of the defining structures on the processes and throughput.

In some examples, as shown in Fig. 30, an edge of a surface of the first portion 310 of the defining structure 300 close to the base substrate 01 protrudes from an edge of a surface of the first portion 310 of the defining structure 30 away from the base substrate 01, and the thickness of the first portion 310 of the defining structure 300 is less than the thickness at least part of the second portion 320 of the defining structure 300. For example, the thickness of the first portion 310 of the defining structure 300 is smaller than the thickness of the part of the second portion 320 of the defining structure 300 that does not overlap with the pixel-defining portion 230. For example, the thickness of the first portion 310 of the defining structure 300 is smaller than the thickness of the part of the second portion 320 of the defining structure 200 that overlaps the pixel-defining portion 230.

For example, as shown in Fig. 30, the thickness of the second portion 320 of the defining structure 300 is greater than that of the pixel-defining portion 230. For example, the thickness at each position of the second portion 320 of the defining structure 300 is greater than that of the pixel-defining portion 230. For example, the thickness of the first portion 310 of the defining structure 300 is smaller than the thickness of the pixel-defining portion 230.

For example, as shown in Fig. 30, the size of the defining structure 300 covering the pixel-defining portion 230 is not greater than 20 microns. For example, the size of the defining structure 300 covering the pixel-defining portion 230 is not greater than 15 microns, or not greater than 14 microns, or not greater than 13 microns, or not greater than 10 microns, or the like.

In the display substrate shown in Fig. 30, except that position relationship of the defining structure and the pixel-defining portion in the direction perpendicular to the base substrate is different, other structures, such as the shapes of the sub-pixels, of the first opening and of the second opening, and the size relationship between the defining structure and the second opening can have the same characteristics as the corresponding structures in the display substrate shown in Fig. 12 to Fig. 29, and will not be described again here.

Fig. 31 is a schematic block diagram of a display device provided according to another embodiment of the present disclosure. Another embodiment of the present disclosure provides a display device including any display substrate as mentioned above.

For example, the display device also includes a cover plate located on the light emitting side of the display substrate.

For example, the display device may be a display device such as an organic light-emitting diode display device and any product or component with a display function, such as a television, a digital camera, a mobile phone, a watch, a tablet computer, a laptop computer, a navigation instrument, or the like, which is not limited in the present embodiment.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate;
a plurality of sub-pixels, located on the base substrate, wherein each of the plurality of sub-pixels comprise a light-emitting functional layer, the light-emitting functional layer comprises a plurality of film layers;
a pixel defining layer, comprising a plurality of openings and a pixel defining portion surrounding the plurality of openings, wherein the plurality of openings comprises a plurality of first openings and a plurality of second openings, each of the plurality of first openings is configured to define a light-emitting region of the sub-pixel, at least a portion of at least one layer of the light-emitting functional layer located in the first opening is a continuous portion, and at least a portion of the at least one layer of the light-emitting functional layer located in each of the plurality of second openings is isolated; and
at least one first defining structure, wherein each of the at least one first defining structure comprises a first portion overlapping with the pixel defining portion and a second portion exposed by the second opening, the second portion of the first defining structure is configured to isolate the at least one layer of the light-emitting functional layer,
wherein the display substrate further comprises at least one support structure, a minimum distance between an orthogonal projection of each of the at least one support structure on the base substrate and an orthogonal projection of the first defining structure on the base substrate is a first distance, a minimum distance between the orthogonal projection of the support structure on the base substrate and an orthogonal projection of the second opening on the base substrate is a second distance, and both the first distance and the second distance are greater than 0 micron and less than 10 microns.

2. The display substrate according to claim 1, wherein both the first distance and the second distance are not less than 2 microns.

3. The display substrate according to claim 1 or 2, wherein a straight-line distance between any two points on an edge of a cross section of the support structure taken by a plane parallel to the base substrate is not greater than 20 microns.

4. The display substrate according to any one of claims 1 to 3, wherein at least a portion of a surface of the support structure away from the base substrate is farther away from the base substrate than the pixel defining portion, and a cross section of the support structure taken by a plane parallel to the base substrate is circular, elliptical or polygonal.

5. The display substrate according to any one of claims 1 to 4, wherein in a direction perpendicular to the base substrate, a size of the support structure is not greater than 10 microns.

6. The display substrate according to claim 1, wherein the first portion of the first defining structure covers the pixel defining portion, and
a slope angle is formed between at least a portion of a side surface of the first portion of the first defining structure away from the second portion of the first defining structure and a first surface of the first portion close to the base substrate, and an angle between the at least a portion of the side surface and a portion of the first surface close to the second portion is less than 90 degrees.

7. The display substrate according to claim 6, wherein in an arrangement direction of adjacent sub-pixels, a maximum size of a cross section of the first defining structure between the adjacent sub-pixels that is taken by a plane is a first size, and a maximum size of a cross section of the first portion of the first defining structure that is taken by the plane is a second size, the second size is not less than 1/2 of the first size and not greater than 10 microns, the plane is parallel to the arrangement direction of the adjacent sub-pixels and perpendicular to the base substrate.

8. The display substrate according to any one of claims 1 to 7, wherein the plurality of sub-pixels comprise a plurality of first sub-pixels, a plurality of second sub-pixels and a plurality of third sub-pixels, and a repeating unit is constituted by one of the plurality of sub-pixels, one of the plurality of second sub-pixels and one of the plurality of third sub-pixels, and
in the repeating unit, the first sub-pixel and the second sub-pixel are arranged sequentially in a first arrangement direction and located at one side of the third sub-pixel in a second arrangement direction, the first arrangement direction intersects with the second arrangement direction.

9. The display substrate according to claim 8, wherein any two adjacent sub-pixels among the first sub-pixel, the second sub-pixel and the third sub-pixel have one first defining structure and one second opening disposed therebetween, and
light-emitting regions of the adjacent sub-pixels are at unequal distances from the second opening between the adjacent sub-pixels, and the second portion of the first defining structure is located between the first portion of the first defining structure and the light-emitting region of one of the adjacent sub-pixels that is closer to the second opening.

10. The display substrate according to claim 8 or 9, wherein a length of an edge of the first defining structure close to the first opening of the sub-pixel is smaller than a length of an edge of the second opening close to the first opening of the sub-pixel, and two ends of the second opening in its extending direction are respectively located at two sides of two ends of the first defining structure overlapping with the second opening.

11. The display substrate according to any one of claims 1 to 7, wherein the plurality of sub-pixels comprise a plurality of first sub-pixels, a plurality of second sub-pixels and a plurality of third sub-pixels, the plurality of sub-pixels are arranged in a plurality of first sub-pixel sets and a plurality of second sub-pixel sets disposed alternately in a first arrangement direction, each of the plurality of first sub-pixel sets comprises one of the plurality of first sub-pixels and one of the plurality of second sub-pixels disposed alternately in a second arrangement direction, and each of the second sub-pixel sets comprises multiple third sub-pixels of the plurality of third sub-pixels arranged in the second arrangement direction, the first arrangement direction intersects with the second arrangement direction; and
each of the plurality of first sub-pixel sets and each of the plurality of second sub-pixel sets are distributed in a staggered manner in the second arrangement direction, each of at least some of the plurality of first sub-pixels is surrounded by eight sub-pixels, and the eight sub-pixels comprise second sub-pixels and third sub-pixels disposed alternately.

12. The display substrate according to any one of claims 1 to 11, wherein the display substrate comprises:
a first region, configured for display, wherein at least some of the plurality of sub-pixels are located in the first region;
a second region, wherein the first region is located at at least one side of the second region;
a third region, located between the first region and the second region,
wherein the display substrate comprises at least one second defining structure located in the third region, an orthogonal projection of each of the least one second defining structure on the base substrate has an annular shape and surrounds the second region, a material of the second defining structure is the same as that of the first defining structure, and at least one layer of the light-emitting functional layer is isolated by an edge portion of the second defining structure not overlapping with the pixel defining portion.

13. The display substrate according to claim 12, wherein the plurality of openings of the pixel defining layer comprise a third opening, the third opening is located in the third region and configured to expose at least a portion of the second defining structure,
the at least one second defining structure comprises at least one of a first sub-defining structure and a second sub-defining structure, the first sub-defining structure is completely exposed by the third opening, and the second sub-defining structure comprises a third portion overlapping with the pixel defining portion and a fourth portion exposed by the third opening, and the fourth portion of the second sub-defining structure is configured to isolate the at least one layer of the light-emitting functional layer.

14. The display substrate according to claim 12, further comprising: a third defining structure, wherein the third defining structure is located in the third region and between the second defining structure and the second region, the pixel defining portion is located at a side of the third defining structure away from the second region, and the third defining structure is configured to isolate at least one film layer of the light-emitting functional layer.

15. The display substrate according to claim 14, wherein an edge of a surface of each of at least one of the first defining structure, the second defining structure and the third defining structure away from the base substrate protrudes relative to an edge of a surface of the each of at least one of the first defining structure, the second defining structure and the third defining structure close to the base substrate.

16. The display substrate according to claim 11, wherein the first portion of the first defining structure is covered by the pixel defining portion, and
an area of the light-emitting region of each of the plurality of third sub-pixels is smaller than that of the light-emitting region of each of the plurality of second sub-pixels, and a distance between the second opening located between the second sub-pixel and the third sub-pixel and the light-emitting region of the third sub-pixel is not smaller than, a distance between the second opening located between the second sub-pixel and the third sub-pixel and the light-emitting region of the second sub-pixel.

17. The display substrate according to claim 16, wherein in an arrangement direction of adjacent sub-pixels, a maximum size of a cross section of the first defining structure between the adjacent sub-pixels that is taken by a plane is a first size, and a maximum size of a cross section of the first portion of the first defining structure that is taken by the plane is a second size, the second size is not less than 1/2 of the first size, the plane is parallel to the arrangement direction of the adjacent sub-pixels and perpendicular to the base substrate.

18. The display substrate according to claim 16 or 17, wherein a length of the second opening in its extending direction is not equal to a length of the first defining structure in its extending direction.

19. The display substrate according to claim 16 or 17, wherein a length of the second opening in its extending direction is equal to a length of the first defining structure in its extending direction, and the first distance is not equal to the second distance.

20. The display substrate according to any one of claims 16 to 19, wherein a maximum size, in the arrangement direction of adjacent sub-pixels, of a cross section of the second opening taken by the plane is not greater than 10 microns.

21. The display substrate according to any one of claims 16 to 20, wherein a length of the second opening in its extending direction is not greater than 50 microns.

22. The display substrate according to any one of claims 16 to 21, wherein a distance between the first defining structure and a first electrode of the sub-pixel is not greater than 15 microns.

23. The display substrate according to any one of claims 16 to 22, wherein a length of an edge of the first defining structure close to the light-emitting region of the sub-pixel is not greater than 50 microns.

24. The display substrate according to any one of claims 16 to 23, wherein the plurality of sub-pixels are arranged in a plurality of sub-pixel rows and a plurality of sub-pixel columns, and
in a direction parallel to the base substrate, a distance between adjacent first defining structures located between two adjacent sub-pixel rows is not greater than 40 microns, and a distance between adjacent first defining structures located between two adjacent sub-pixel columns is not greater than 40 microns.

25. A display panel, comprising the display substrate according to any one of claims 1 to 24.

26. A display device, comprising the display substrate according to any one of claims 1 to 24.
